# EUROPEAN PATENT SPECIFICATION

(11) **EP 2 166 410 B1**
(45) Date of publication and mention of the grant of the patent: **11.12.2013**
(21) Application number: 09170935.2
(22) Date of filing: 22.09.2009
(51) Int. Cl.: B41N 3/03, G03F 7/32, B41C 1/10, G03F 7/027, G03F 7/004

(54) **Method of preparing lithographic printing plate**
Verfahren zur Herstellung einer lithografischen Druckplatte
Procédé de préparation de plaque d'impression lithographique

(30) Priority: 22.09.2008 JP 2008243374; 31.03.2009 JP 2009088552
(43) Date of publication of application: 24.03.2010
(73) Proprietor: Fujifilm Corporation, Minato-ku Tokyo (JP)
(72) Inventor: Fujii, Shigekatsu, Shizuoka (JP); Kuramoto, Mamoru, Shizuoka (JP); Arimura, Keisuke, Shizuoka (JP)
(74) Representative: HOFFMANN EITLE

(56) References cited:
- EP-A1- 0 537 633
- EP-A2- 1 251 014
- EP-A2- 1 348 570
- JP-A- 2005 329 663

## Description

### FIELD OF THE INVENTION

The present invention relates to a method of preparing a lithographic printing plate. More particularly, it relates to a method of preparing a lithographic printing plate which does not cause fluctuation in characteristics of the image formed even when the lithographic printing plate precursor is preserved before image exposure and which includes a monobath development processing to provide a lithographic printing plate excellent in printing durability and stain resistance.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous alkali solution having pH of 11 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, a developing method of processing with a developer having pH of 8.5 to 11.5 and a dielectric constant of 3 to 30 mS/cm and containing an alkali metal carbonate and an alkali metal hydrogen carbonate is proposed in JP-A-11-65126 (the term "JP-A" as used herein means an "unexamined published Japanese patent application"). However, since the developing method is required a water-washing step and a treatment step with a gum solution, it does not resolve the problems of the environment and running cost.

Also, processing with a processing solution having pH of 11.9 to 12.1 and containing a water-soluble polymer compound is described in the example of EP-A-1868036. However, since the printing plate obtained by the processing is left in the state that the alkali of pH 12 adheres on the surface thereof, a problem in view of safety of an operator arises and with the lapse of long time after the preparation of the printing plate until the initiation of printing, the image area gradually dissolves to result in deterioration in printing durability or ink-receptive property. In JP-T-2007-538279 (the term "JP-T" as used herein means a published Japanese translation of a PCT patent application), processing with a processing solution having pH of 3 to 9 and containing a water-soluble polymer compound is described. However, since the processing solution does not contain a basic component, it is necessary to enable development by making a polymer used in a photosensitive layer hydrophilic and thus, a problem occurs in that printing durability severely degrades.

In JP-A-2005-329663, a photosensitive lithographic printing plate material having an image-forming layer on an aluminum support which is obtained by treating an aluminum plate subjected to a surface roughening treatment and anodizing treatment with an aqueous solution having pH of 2.0 to 2.4 and containing polyvinylphosphonic acid and from 20 to 400 ppm of a divalent cation is described. However, the photosensitive lithographic printing plate material needs pre-water washing, alkali development, water washing and gumming for plate making thereof after image exposure and thus, the problems of space saving, disposal of the waste liquid, environment, running cost and the like are not resolved.

EP-A- 1 251 014 discloses a method for preparing a lithographic printing plate. The method comprises imagewise exposing a lithographic printing plate precursor comprising a photosensitive layer containing a sensitising dye, a polymerisation initiator, a polymerizable compound and a binder polymer, and an aluminium support on which divalent cations are adsorbed in an amount of from 0.5 to 3.0 mg/m² prepared by treating the aluminium support with an aqueous polyvinylphosphonic acid solution and washing the treated aluminium support with an aqueous solution containing the divalent cations. The exposed lithographic printing plate precursor is then subjected to development processing in a monobath.

### SUMMARY OF THE INVENTION

Therefore, an object of the present invention is to provide a method of preparing a lithographic printing plate which overcomes the problems of the prior art. More specifically, it is to provide a method of preparing a lithographic printing plate which does not cause fluctuation in characteristics of the image formed (that is, excellent in preservation stability) even when the lithographic printing plate precursor is preserved before image exposure and which includes a monobath development processing to provide a lithographic printing plate excellent in printing durability and stain resistance and a lithographic printing plate precursor for use in the method.

As a result of the intensive investigations, the inventor has found that the above-described object can be achieved by the constitution described below to complete the present invention.

Specifically, the present invention includes the following items.
(1) A method for preparing a lithographic printing plate comprising imagewise exposing a lithographic printing plate precursor comprising a photosensitive layer containing a sensitizing dye, a polymerization initiator, a polymerizable compound and a binder polymer and an aluminum support on which a divalent cation is adsorbed in an amount of from 0.5 to 3.0 mg/m² prepared by treating the aluminum support with an aqueous polyvinylphosphonic acid solution and washing the treated aluminum support with an aqueous solution containing the divalent cation; and subjecting the exposed lithographic printing plate precursor to development processing in a monobath with a developer which has a pH of from 2 to 11 and which comprises a pH buffer agent and a surfactant.
(2) The method of preparing a lithographic printing plate as described in (1) above, wherein the pH buffer agent is a combination of a carbonate ion and a hydrogen carbonate ion.
(3) The method of preparing a lithographic printing plate as described in any one of (1) to (2) above, wherein the developer contains a water-soluble resin.
(4) The method of preparing a lithographic printing plate as described in any one of (1) to (3) above, wherein the sensitizing dye is a dye having an absorption maximum in a wavelength range of 350 to 450 nm.
(5) The method of preparing a lithographic printing plate as described in any one of (1) to (3) above, wherein the sensitizing dye is a dye having an absorption maximum in a wavelength range of 750 to 1,400 nm.
(6) The method of preparing a lithographic printing plate as described in any one of (1) to (5) above, wherein the polymerizable compound has a urea group and/or a tertiary amino group.

According to the present invention, a method of preparing a lithographic printing plate which does not cause fluctuation in characteristics of the image formed even when the lithographic printing plate precursor is preserved before image exposure and which can prepare a lithographic printing plate excellent in printing durability and stain resistance can be provided in spite of a monobath development processing. Further, by conducting the monobath development processing, advantages, for example, the simplification of processing step, consideration for global environment, and adaptation for space saving and low running cost are achieved.

### BRIEF DESCRIPTION OF THE DRAWINGS

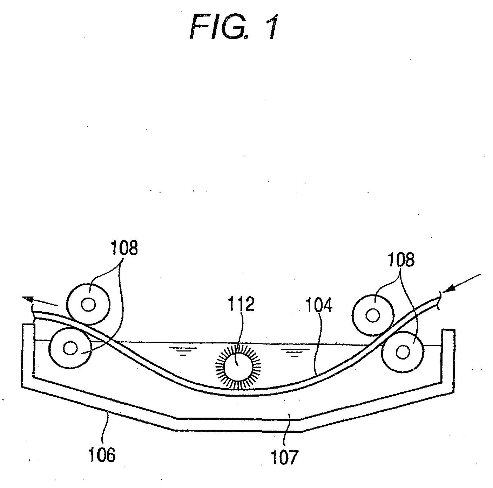

Fig. 1 is an illustration showing a structure of an automatic development processor.

### DETAILED DESCRIPTION OF THE INVENTION

### [Lithographic printing plate precursor]

The lithographic printing plate precursor for use in the method of the invention is a lithographic printing plate precursor which is capable of undergoing a monobath development processing with a developer and comprises a photosensitive layer containing a sensitizing dye, a polymerization initiator, a polymerizable compound and a binder polymer on an aluminum support on which a divalent cation is adsorbed in an amount of 0.5 to 3.0 mg/m² prepared by treating the aluminum support with an aqueous polyvinylphosphonic acid solution and then washing it with an aqueous solution containing a divalent cation.

### [Aluminum support]

An aluminum substrate for use in the production of the aluminum support according to the invention may be any substrate having aluminum or its alloy on its surface and includes, for example, a plate of aluminum or its alloy (for example, an alloy containing silicon, copper, manganese, magnesium, chromium, zinc, lead, bismuth or nickel), paper or a plastic film having laminated with or vapor-deposited thereon aluminum or its alloy, and a composite sheet comprising a polyethylene terephthalate film having bonded thereon an aluminum sheet as described in JP-B-48-18327 (the term "JP-B" as used herein means an "examined Japanese patent publication"). Ordinarily, the thickness of the support is approximately from 0.05 to 1 mm.

The aluminum substrate is preferably subjected to a surface treatment, for example, a graining treatment, an anodizing treatment, or a hydrophilizing treatment with an aqueous solution, for example, of sodium silicate, potassium fluorozirconate or a phosphate.

### (Graining treatment)

For the graining treatment, an electrochemical graining method wherein surface graining is electrochemically conducted in an electrolytic solution of hydrochloric acid or nitric acid or a mechanical graining method, for example, a wire brush graining method wherein a surface of aluminum substrate is scratched with a wire brush, a ball graining method wherein a surface of aluminum substrate is grained with abrasive balls and an abrasive or a brush graining method wherein a surface of aluminum substrate is grained with a nylon brush and an abrasive can be employed. The graining methods may be used in combination of two or more thereof. For instance, a method of conducting mechanical graining, chemical etching and electrolytic graining is described in JP-A-56-28893.

A method of forming useful surface roughness is an electrochemical graining method wherein surface graining is chemically conducted in an electrolytic solution of hydrochloric acid or nitric acid. Specifically, it is preferred to perform electrolysis in an electrolytic solution containing from 0.1 to 50% by weight of hydrochloric acid or nitric acid under the conditions of temperature from 20 to 100°C, time from one second to 30 minutes and current density from 100 to 400 Coulomb/dm².

The aluminum substrate subjected to the graining treatment is then chemically etched with an acid or an alkali. The method of using an acid as an etching agent takes time for destroying fine structures. Such a problem may be resolved by using an alkali as the etching agent.

Examples of the alkali agent preferably used include sodium hydroxide, sodium carbonate, sodium aluminate, sodium metasilicate, sodium phosphate, potassium hydroxide and lithium hydroxide. Preferable ranges of the concentration and temperature are form 1 to 50% and 20 to 100°C, respectively. The conditions for providing a dissolution amount of aluminum in a range from 5 to 20 g/m³ are preferable.

After the etching procedure, the aluminum substrate is subjected to washing with an acid for removing stain (smut) remaining on the surface thereof. Examples of the acid for use in the acid-washing step include nitric acid, sulfuric acid, phosphoric acid, chromic acid, hydrofluoric acid and hydrofluoroboric acid. As the method for removing smut after the electrochemical graining treatment, a method of bringing the aluminum substrate into contact with a 15 to 65% by weight aqueous sulfuric acid solution having a temperature of 50 to 90°C as described in JP-A-53-12739 and a method of performing alkali etching as described in JP-B-48-28123 are preferred.

Surface roughness (Ra) of the aluminum substrate is preferably from 0.3 to 0.7 µm.

### (Anodizing treatment)

The aluminum substrate subjected to the graining treatment may be further subjected to anodizing treatment. The anodizing treatment can be conducted in a manner conventionally used in the field of art.

Specifically, it is performed by applying direct current or alternating current to the aluminum substrate in an aqueous solution or non-aqueous solution containing sulfuric acid, phosphoric acid, chromic acid, oxalic acid, sulfamic acid, benzenesulfonic acid, or a combination of two or more thereof to form an anodic oxide film on the surface of aluminum substrate.

The conditions of anodizing treatment cannot be determined generally, since they vary widely depending on the electrolytic solution to be used. However, it is ordinarily suitable that a concentration of the electrolytic solution is in a range from 1 to 80%, a temperature of the electrolytic solution is in a range from 5 to 70°C, a current density is in a range from 0.5 to 60 Ampere/dm², a voltage is in a range from 1 to 100 V, and a period of electrolysis is in a range from 10 to 100 seconds.

Of the anodizing treatments, a method of anodizing in a sulfuric acid solution with a high current density described in British Patent 1,412,768 and a method of anodizing using phosphoric acid as an electrolytic bath described in U.S. Patent 3,511,661 are preferably used.

The amount of anodic oxide film is preferably from 1 to 10 g/m². When the amount is less than 1 g/m², the printing plate is apt to be scratched. When the amount exceeds 10 g/m², a large quantity of electric power is necessary and thus it is economically disadvantageous. The amount of anodic oxide film is more preferably from 1.5 to 7 g/m², and still more preferably from 2 to 5 g/m².

The aluminum substrate may further be subjected to a sealing treatment of the anodic oxide film after the graining treatment and anodizing treatment. The sealing treatment is performed by immersing the aluminum substrate in hot water or a hot aqueous solution containing an inorganic salt or an organic salt, or transporting the aluminum substrate in a water vapor bath. Moreover, the aluminum substrate may be subjected to a surface treatment, for example, silicate treatment with an alkali metal silicate or immersion treatment in an aqueous solution, for example, of potassium fluorozirconate or a phosphate.

Next, the aluminum substrate is treated with an aqueous polyvinylphosphonic acid solution and then washed with an aqueous solution containing a divalent cation to prepare an aluminum support on which the divalent cation is adsorbed in an amount of 0.5 to 3.0 mg/m².

The treatment with an aqueous polyvinylphosphonic acid solution and washing with an aqueous solution containing a divalent cation (preferably, having the divalent cation concentration of 20 to 400 ppm) can be performed, for example, in the following method. A processing solution is prepared by dissolving 0.4% by weight of polyvinylphosphonic acid (for example, produced by PCAS) in pure water. In the processing solution maintained at 53°C, an aluminum substrate having an anodic oxide film is immersed for 10 seconds and the excess processing solution is removed by a nip roll. Then, the aluminum substrate is washed with an aqueous solution having a divalent cation concentration of 75 ppm at 60°C for 4 seconds and further with pure water at 25°C for 4 seconds, followed by removing the excess pure water by a nip roll. Thereafter, the aluminum substrate is dried to remove water thereby obtaining an aluminum support.

From the standpoint of preservation stability, stain resistance and printing durability, a cation of an alkaline earth metal is desirable and a cation of calcium or magnesium is more desirable, as the divalent cation.

The weight of the cation adsorbed on the support is suitably from 0.5 to 3.0 mg/m², preferably from 1.0 to 2.5 mg/m², and more preferably from 1.5 to 2.5 mg/m².

Measurement of the adsorption amount of divalent cation on the aluminum support can be performed according to a conventional manner. It is described below using a calcium ion as an example. The adsorption amount of calcium ion is measured as an amount (mg/m²) of calcium atom by a calibration curve method using X-ray fluorescence spectrometer (XRF). A standard sample used for preparing the calibration curve is prepared by dropping uniformly an aqueous calcium chloride solution containing a known amount of calcium atom in an area of 30 mm Φ on a support and drying. The model of X-ray fluorescence spectrometer is not particularly restricted. Specifically, in the examples described hereinafter, RIX3000 produced by Rigaku Corp. was used and the amount of calcium atom was determined from a peak height of Ca-Kα spectrum under the following conditions:
X-ray tube: Rh
Measurement spectrum: Ca-Ka
X-ray tube voltage: 50 kV
X-ray tube current: 50 mA
Slit: Std
Dispersive crystal: GE
Detector: PC
Analysis area: 30 mm Φ
Peak position (20): 61.95 deg.
Background (2θ): 59.5 deg., 64.5 deg.
Integration time: 80 sec/sample

### [Photosensitive layer]

The photosensitive layer (hereinafter, also referred to as an image-recording layer) of the lithographic printing plate precursor for use in the invention contains a sensitizing dye, a polymerization initiator, a polymerizable compound and a binder polymer.

The components constituting the photosensitive layer are described in more detail below.

### (Sensitizing dye)

By incorporating the sensitizing dye, for example, a sensitizing dye having an absorption maximum in a wavelength range of 350 to 450 nm or an infrared absorbing agent having an absorption maximum in a wavelength range of 750 to 1,400 nm into the photosensitive layer, a highly sensitive lithographic printing plate precursor responding to violet laser of 405 nm or IR laser of 803 nm ordinarily used in the field of technology can be provided, respectively.

First, the sensitizing dye having an absorption maximum in a wavelength range of 350 to 450 nm is described below. Such sensitizing dyes include, for example, merocyanine dyes, benzopyrans, coumarins, aromatic ketones and anthracenes.

Of the sensitizing dyes having an absorption maximum in a wavelength range of 350 to 450 nm, dyes represented by formula (IV) shown below are preferable in view of high sensitivity.

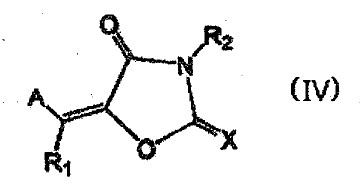

In formula (IV), A represents an aromatic cyclic group which may have a substituent or a heterocyclic group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (IV) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

A in formula (IV) represents an aromatic cyclic group which may have a substituent or heterocyclic group which may have a substituent. The aromatic cyclic group which may have a substituent and heterocyclic group which may have a substituent include are same as the substituted or unsubstituted aryl group and substituted or unsubstituted aromatic heterocyclic residue described for any one of R₁, R₂ and R₃ in formula (IV), respectively.

Specific examples of the sensitizing dye include compounds described in Paragraph Nos. [0047] to [0053] of JP-A-2007-58170.

Further, sensitizing dyes represented by formulae (V) to (VII) shown below can also be used.

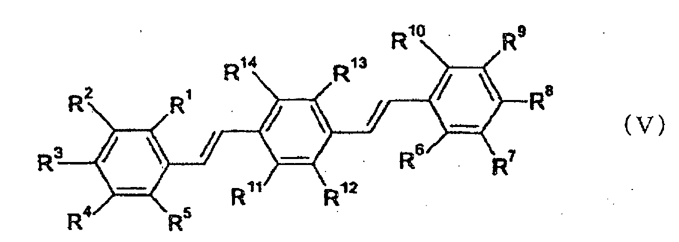

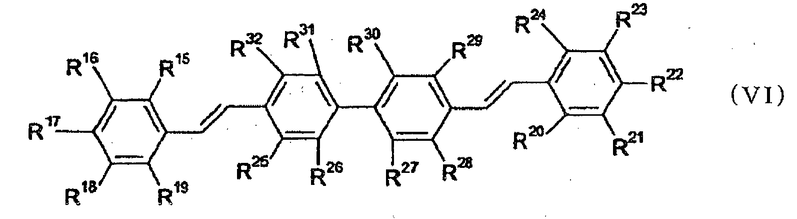

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

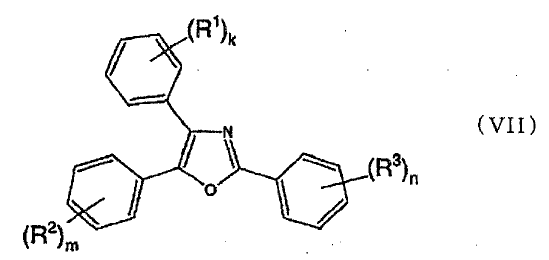

In formula (VII), R¹, R² and R³ each independently represents a halogen atom, an alkyl group, an aryl group, an aralkyl group, an -NR⁴R⁵ group or an -OR⁶ group, R⁴, R⁵ and R⁶ each independently represents a hydrogen atom, an alkyl group, an aryl group or an aralkyl group, and k, m and n each represents an integer of 0 to 5.

Sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

The amount of the sensitizing dye having an absorption maximum in a wavelength range of 350 to 450 nm added is preferably from 0.05 to 30 parts by weight, more preferably from 0.1 to 20 parts by weight, most preferably from 0.2 to 10 parts by weight, per 100 parts by weight of the total solid content of the photosensitive layer.

Next, the sensitizing dye having an absorption maximum in a wavelength range of 750 to 1,400 preferably used in the invention is described in detail below.

Such sensitizing dyes include infrared absorbing agents and it is believed that the sensitizing dye forms an electron excited state with high sensitivity upon irradiation (exposure) of infrared laser, and electron transfer, energy transfer or heat generation (light-to-heat conversion function) relating to the electron excited state acts on a polymerization initiator coexistent in the photosensitive layer to cause chemical change in the polymerization initiator, thereby generating a radical. In any event, it is particularly preferable for plate making including direct drawing with the infrared laser having a wavelength of 750 to 1,400 nm to add the sensitizing dye having an absorption maximum in a wavelength range of 750 to 1,400 and the high image-forming property can be generated in comparison with a conventional lithographic printing plate precursor.

The infrared absorbing agent is preferably a dye or pigment having an absorption maximum in a wavelength range of 750 to 1,400 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

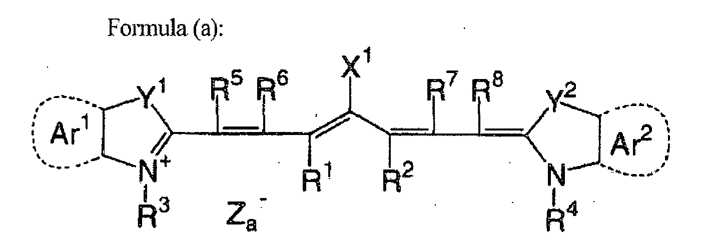

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom or a hydrocarbon group having from 1 to 12 carbon atoms and containing a hetero atom. The hetero atom indicates herein a nitrogen atom, a sulfur atom, an oxygen atom, a halogen atom or a selenium atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

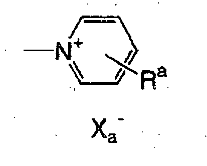

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms, and it is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (a) has an anionic substituent in the structure thereof and neutralization of charge is not needed. Preferable examples of the counter ion for Za⁻ include a halogen ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a), which can be preferably used in the invention, include those described in Paragraph Nos. [0017] to [0019] of JP-A-2001-133969.

Further, other particularly preferable examples include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after the surface treatment. For the surface treatment, a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984) and Saishin Ganryo Oyo Gijutsu (Newest Application on Technologies for Pigments), CMC Publishing Co., Ltd. (1986).

The pigment has a particle size of preferably from 0.01 to 10 µm, more preferably from 0.05 to 1 µm, and particularly preferably from 0.1 to 1 µm. In the preferable range of particle size, excellent dispersion stability of the pigment in the photosensitive layer is achieved and a uniform photosensitive layer can be obtained.

For dispersing the pigment, known dispersion techniques for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganyo Oyo Gijutsu (Newest Application on Technologies for Pigments), CMC Publishing Co., Ltd. (1986).

The infrared absorbing agent may be added together with other components to the same layer or a different layer separately provided.

The infrared absorbing agent is added ordinarily in an amount of 0.01 to 50% by weight, preferably in an amount of 0.1 to 10% by weight, particularly preferably in an amount of 0.5 to 10% by weight in case of the dye and in an amount of 0.1 to 10% by weight in case of the pigment, based on the total solid content constituting the photosensitive layer, from the standpoint of uniformity in the photosensitive layer and printing durability of the photosensitive layer.

### (Polymerization initiator)

The photosensitive layer according to the invention contains a polymerization initiator (hereinafter, also referred to as an initiator compound). The initiator compound is a compound undergoing chemical change upon a function, for example, electron transfer, energy transfer or heat generation resulting from the sensitizing dye in the electron excited state to generate at least one species selected from a radical, an acid or a base. The radical, acid or base thus-generated is simply referred to as an active species, hereinafter. When the initiator compound is not present or when it is used alone, sensitivity sufficient for practical use can not be obtained. According to one embodiment of using the sensitizing dye together with the initiator compound, it is possible to utilize a single compound including both compounds prepared by an appropriate chemical method (for example, a linkage of the sensitizing dye and the initiator compound by a chemical bond).

It is believed that many of the initiator compounds ordinarily generate the active species through an initial chemical process as typified by following processes (1) to (3). Specifically, there are a process (1): reductive decomposition of the initiator compound based on electron transfer from the sensitizing dye in the electron excited state to the initiator compound, a process (2): oxidative decomposition of the initiator compound based on electron transfer from the initiator compound to the sensitizing dye in the electron excited state, and a process (3): decomposition of the initiator compound in the electron excited state based on energy transfer from the sensitizing dye in the electron excited state to the initiator compound. Although it is unclear in many cases that an individual initiator compound decomposes according to which process belongs to (1) to (3), in the invention the sensitizing dye has a great feature in that it exhibits a very large sensitizing effect even in combination with any initiator compounds decomposed according to the processes (1) to (3).

As the initiator compound according to the invention, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferable, and the hexaarylbiimidazole compound is particularly preferable. The polymerization initiators may be appropriately used in combination of two or more thereof

The hexaarylbiimidazole compound includes, for example, lophine dimers described in JP-B-45-37377 and JP-B-44-86516, specifically,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,
2,2'-bis(o-methylphenyl)-4,4',5,5'-tetraphenylbiimidazole and
2,2'-bis(o-trifluoromethylphenyl)-4,4',5,5'-tetraphenylbiimidazole.

The hexaarylbiimidazole compound is particularly preferably used together with the sensitizing dye having an absorption maximum in a wavelength range of 350 to 450 nm.

The onium salt (which functions not as an acid-generator, but an ionic polymerization initiator in the invention) preferably used in the invention includes onium salts represented by the following formulae (RI-I) to (RI-III):

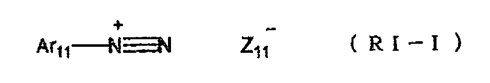

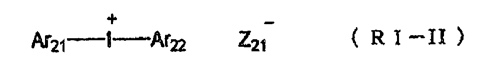

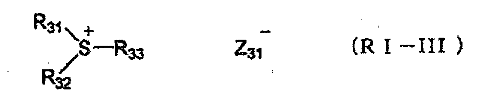

In formula (RI-I), Ar₁₁ represents an aryl group having 20 or less carbon atoms, which may have 1 to 6 substituents. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 2 to 12 carbon atoms, an alkylamido group or arylamido group having from 2 to 12 carbon atoms, a carbonyl group, a carboxyl group, a cyano group, a sulfonyl group, an thioalkyl group having from 1 to 12 carbon atoms and an thioaryl group having from 6 to 12 carbon atoms. Z₁₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion and a sulfate ion. Among them, a perchlorate ion, a hexafluorophosphate ion, a tetrafluoroborate ion, a sulfonate ion and a sulfinate ion are preferred in view of stability.

In formula (RI-II), Ar₂₁ and Ar₂₂ each independently represents an aryl group having 20 or less carbon atoms, which may have 1 to 6 substituents. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 2 to 12 carbon atoms, an alkylamido group or arylamido group having from 2 to 12 carbon atoms, a carbonyl group, a carboxyl group, a cyano group, a sulfonyl group, an thioalkyl group having from 1 to 12 carbon atoms and an thioaryl group having from 6 to 12 carbon atoms. Z₂₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In formula (RI-III), R₃₁, R₃₂ and R₃₃ each independently represents an aryl group having 20 or less carbon atoms, which may have 1 to 6 substituents, an alkyl group, an alkenyl group or an alkynyl group. Among them, the aryl group is preferred in view of reactivity and stability. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 2 to 12 carbon atoms, an alkylamido group or arylamido group having from 2 to 12 carbon atoms, a carbonyl group, a carboxyl group, a cyano group, a sulfonyl group, an thioalkyl group having from 1 to 12 carbon atoms and an thioaryl group having from 6 to 12 carbon atoms. Z₃₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferable, and carboxylate ions described in JP-A-2002-148790 are particularly preferable.

The onium salt is particularly preferably used together with the infrared absorbing agent having an absorption maximum in a wavelength range of 750 to 1,400 nm.

In addition, polymerization initiators described in JP-A-2007-171406, JP-A-2007-206216, JP-A-2007-206217, JP-A-2007-225701, JP-A-2007-225702, JP-A-2007-316582 and JP-A-2007-328243 are preferably used.

The polymerization initiators are preferably used individually or in combination of two or more thereof according to the invention.

The amount of the polymerization initiator used in the photosensitive layer according to the invention is preferably from 0.01 to 20% by weight, more preferably from 0.1 to 15% by weight, still more preferably from 1.0 to 10% by weight, based on the total solid content of the photosensitive layer.

### (Polymerizable compound)

The polymerizable compound for use in the photosensitive layer according to the invention is an addition-polymerizable compound having at least one ethylenically unsaturated double bond, and it is selected from compounds having at least one, preferably two or more, terminal ethylenically unsaturated double bonds. Such compounds are widely known in the field of industry and they can be used in the invention without any particular limitation. The polymerizable compound has a chemical form, for example, a monomer, a prepolymer, specifically, a dimer, a trimer or an oligomer, or a copolymer thereof, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include, as an acrylic acid ester, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate and polyester acrylate oligomer.

As a methacrylic acid ester, for example, tetramethylene glycol dimethacrylate, triethylene glycol dimethacrylate, neopentyl glycol dimethacrylate, trimethylolpropane trimethacrylate, trimethylolethane trimethaclylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)phenyl]dimethylmethane are exemplified.

As an itaconic acid ester, for example, ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate are exemplified. As a crotonic acid ester, for example, ethylene glycol dicrotonate, tetramethylene glycol dicrotonate, pentaerythritol dicrotonate and sorbitol tetracrotonate are exemplified. As an isocrotonic acid ester, for example, ethylene glycol diisocrotonate, pentaerythritol diisocrotonate and sorbitol tetraisocrotonate are exemplified. As a maleic acid ester, for example, ethylene glycol dimaleate, triethylene glycol dimaleate, pentaerythritol dimaleate and sorbitol tetramaleate are exemplified.

Other examples of the ester, which can be preferably used, include aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

Polymerizable compounds undergoing photo-oxidation are also preferable and Polymerizable compounds containing at least one urea group and/or a tertiary amino group described in JP-T-2007-506125 are particularly preferable.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formulae (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photosensitive layer having remarkably excellent photo-speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use or an amount added, can be appropriately determined in accordance with the characteristic design of the final lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to the support, a protective layer or the like described hereinafter. In the method of using the polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

The polymerizable compound is used preferably in a range of 5 to 75% by weight, more preferably in a range of 25 to 70% by weight, particularly preferably in a range of 30 to 60% by weight, based on the total solid content of the photosensitive layer.

### (Binder polymer)

The binder polymer for use in the invention is not particularly restricted and from the standpoint of solubility in an aqueous week alkali solution and developing property, an organic polymer having an acid group is preferable and an organic polymer having a carboxylic acid is more preferable. Examples of such an organic polymer include addition polymers having a carboxylic acid group in their side chains, for example, polymers described in JP-A-59-44615, JP-B-54-34327, JP-B-58-12577, JP-B-54-25957, JP-A-54-92723, JP-A-59-53836 and JP-A-59-71048, specifically, methacrylic acid copolymers, acrylic acid copolymers, itaconic acid copolymers, crotonic acid copolymers, maleic acid copolymers and partially esterified maleic acid copolymers.

Also, an acidic cellulose derivative having a carboxylic acid group in its side chain and a product obtained by adding a cyclic acid anhydride to an addition polymer having a hydroxy group are exemplified.

Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as a binder polymer soluble or swellable in an aqueous weak alkali solution.

As the binder polymer, an acrylic resin, a methacrylic resin or a urethane resin is preferably used.

Preferable examples of the binder polymer for use in the invention include an acrylic polymer containing (meth)acrylic acid as a copolymerization component. The content of (meth)acrylic acid is preferably from 5 to 70% by weight, more preferably from 10 to 50% by weight, most preferably from 10 to 40% by weight, based on the total copolymerization component from the standpoint of developing property.

As the binder polymer, a copolymer of (meth)acrylic acid and an alkyl ester of (meth)acrylic acid is preferable. As the alkyl group of the alkyl ester of (meth)acrylic acid, a straight-chain, branched or cyclic alkyl group having from 1 to 10 carbon atoms is preferable. The copolymerization weight ratio of (meth)acrylic acid and alkyl ester of (meth)acrylic acid is preferably from 30:70 to 95:5, more preferably from 50:50 to 90:10, and most preferably from 60:40 to 90:10.

One preferable example of the binder polymer for use in the invention is a copolymer having (a) a repeating unit containing a carboxylic acid and (b) a repeating unit imparting a radical crosslinking property.

Specific examples of the repeating unit (a) containing a carboxylic acid (hereinafter, also referred to as repeating unit (a)) include the structures represented by (a-1) to (a-12) set forth below, but the invention should not be construed as being limited thereto.

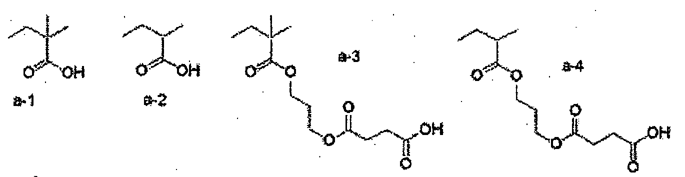

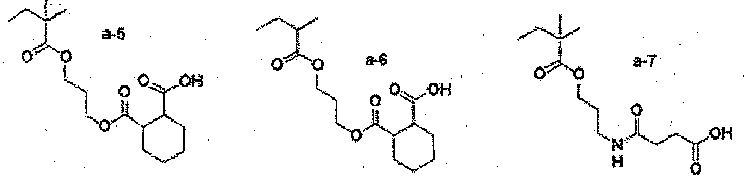

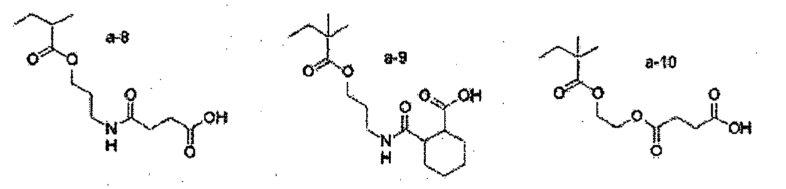

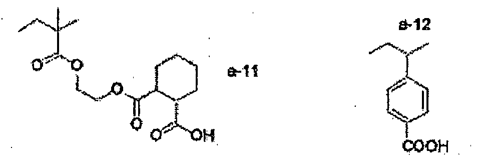

The content of the repeating unit (a) is ordinarily from 5 to 50, preferably from 5 to 25, more preferably from 5 to 15, taking the number of the total repeating units as 100.

Specific examples of the repeating unit (b) imparting a radical crosslinking property (hereinafter, also referred to as repeating unit (b)) include the structures represented by (b-1) to (b-11) set forth below, but the invention should not be construed as being limited thereto.

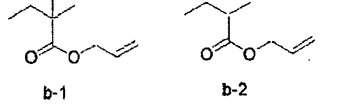

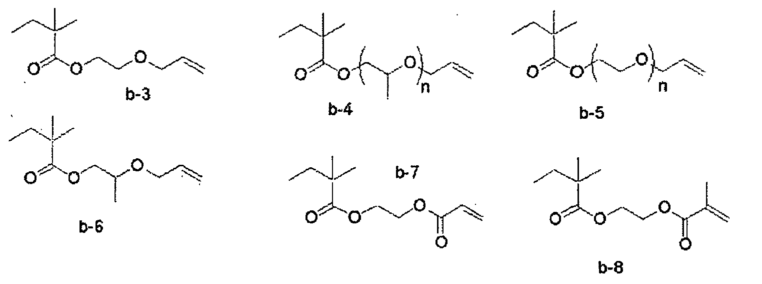

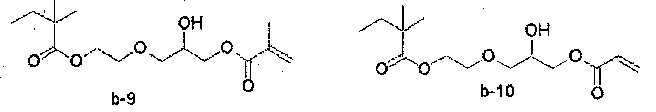

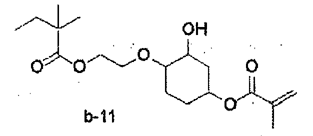

The content of the repeating unit (b) is ordinarily from 5 to 90, preferably from 20 to 85, more preferably from 40 to 80, taking the number of the total repeating units as 100.

The binder polymer for use in the invention may further have a repeating unit (hereinafter, also referred to as repeating unit (1)) represented by formula (1) shown below.

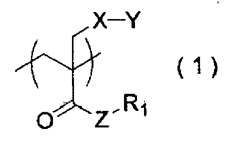

In formula (1), X represents an oxygen atom, a sulfur atom or a -NH- group, Y represents a hydrogen atom, an alkyl group having from 1 to 12 carbon atoms, a cyclic alkyl group having from 5 to 12 carbon atoms or a group including an aromatic ring having from 6 to 20 carbon atoms, Z represents an oxygen atom, a sulfur atom or a -NH- group, and R₁ represents an alkyl group having from 1 to 18 carbon atoms, an alkyl group including an alicyclic structure having from 5 to 20 carbon atoms or a group containing an aromatic ring having from 6 to 20 carbon atoms.

Specific examples of the repeating unit (1) include the structures represented by (1-1) to (1-9) set forth below, but the invention should not be construed as being limited thereto.

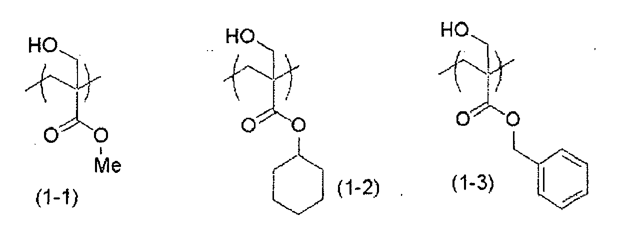

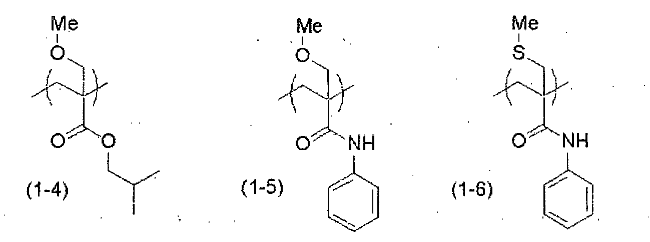

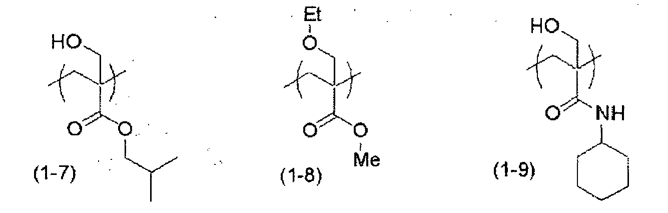

The content of the repeating unit (1) is ordinarily from 1 to 40, preferably from 3 to 25, more preferably from 5 to 15, taking the number of the total repeating units as 100.

Specific examples of the binder polymer comprising a preferable combination of the repeating units (a), (b) and (1) include Nos. (PP-1) to (PP-11) shown in Table 1 below, but the invention should not be construed as being limited thereto.

**TABLE 1**

| No. | Repeating Unit (1) | Repeating Unit (a) | Repeating Unit (b) |
|---|---|---|---|
| PP-1 | 1-3 | a-1 | b-1 |
| PP-2 | 1-3 | a-1 | b-8 |
| PP-3 | 1-2 | a-1 | b-1 |
| PP-4 | 1-2 | a-1 | b-8 |
| PP-5 | 1-2 | a-1 | b-11 |
| PP-6 | 1-9 | a-5 | b-1 |
| PP-7 | 1-5 | a-3 | b-1 |
| PP-8 | 1-5 | a-3 | b-8 |
| PP-9 | 1-1 | a-3 | b-1 |
| PP-10 | 1-1 | a-5 | b-8 |
| PP-11 | 1-9 | a-3 | b-1 |

It is preferred that a urethane resin used as the binder polymer in the invention contains a crosslinkable group. The term "crosslinkable group" as used herein means a group capable of crosslinking the binder polymer in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bonding group, an amino group or an epoxy group as a functional group capable of undergoing an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferable, and functional groups represented by formulae (1A) to (3A) shown below are particularly preferable.

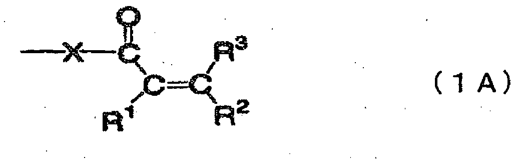

In formula (1A), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity.

R² and R³ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The monovalent organic group represented by R¹² includes, for example, an alkyl group which may have a substituent. Among them, R¹² is preferably a hydrogen atom, a methyl group, an ethyl group or an isopropyl group because of high radical reactivity.

Examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

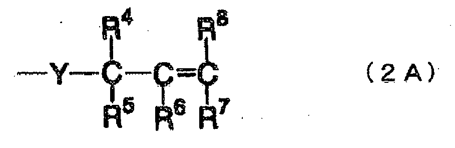

In formula (2A), R⁴ to R⁸ each independently represents a hydrogen atom or a monovalent organic group. R⁴ to R⁸ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable.

Examples of the substituent which can be introduced include those described in formula (1A). Y represents an oxygen atom, a sulfur atom or -N(R¹²)-, and R¹² has the same meaning as R¹² defined in formula (1A). Preferable examples for R¹² are also same as those described in formula (1A).

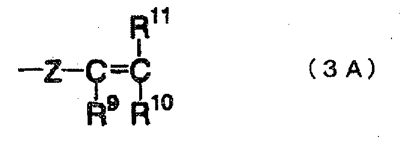

In formula (3A), R⁹ to R¹¹ each independently represents a hydrogen atom or a monovalent organic group. R⁹ is preferably a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

Examples of the substituent introduced include those described in Formula (1A). Z represents an oxygen atom, a sulfur atom, -N(R¹²)- or a phenylene group which may have a substituent. R¹² has the same meaning as R¹² defined in formula (1A). Preferable examples for R¹² are also same as those described in formula (1A).

The polyurethane resin for use in the invention preferably contains in its side chain an aqueous week alkali-soluble group, for example, a carboxyl group as well as the crosslinkable group. The polyurethane resin is preferable in view of satisfying both good stain resistance and high printing durability because the development damage in the exposed area can be prevented without accompanying with deterioration of the developing property in the unexposed area, even when the acid value of the image-recording layer is low.

The polyurethane resin preferably used in the invention is a resin obtained by a polyaddition reaction of (i) a diisocyanate compound, (ii) a diol compound having a carboxyl group, (iii) a diisocyanate compound having a crosslinkable group and, if desired, (iv) a diol compound containing no carboxyl group.

The diisocyanate compound and diol compound which are starting materials of the polyurethane resin will be described in more detail below.

### (i) Diisocyanate compound,

Examples of the diisocyanate compound include diisocyanate compounds represented by the following formula (4):

OCN-L-NCO (4)

In formula (4), L represents a single bond or a divalent aliphatic or aromatic hydrocarbon group which may have a substituent. If desired, L may contain other fictional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent. (preferably, for example, an alkyl group, an aralkyl group, an aryl group, an alkoxy group or a halogen atom), preferably an alkylene group having from 1 to 20 carbon atoms or an arylene group having from 6 to 1 carbon atoms, more preferably an alkylene group having from 1 to 8 carbon atoms. Also, if desired, L may contain other functional group which does not react with the isocyanate group, for example, a carbonyl group, an ester group, a urethane group, an amido group, a ureido group or an ether group.

Specific examples of the diisocyanate compound represented by formula (4) include the following compounds. Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthalene diisocyanate or 3,3'-dimethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol with 2 moles of tolylene diisocyanate are exemplified.

The diisocyanate compounds may be used individually or in combination of two or more thereof. In view of the balance between printing durability and stain resistance, it is preferred to use two or more of the diisocyanate compounds in combination, and it is particularly preferred to use at least one of the aromatic diisocyanate compounds (L, represents an aromatic group) and at least one of the aliphatic diisocyanate compounds (L represents an aliphatic group).

With respect to the amount of the diisocyanate compound used, a molar ration of the diisocyanate compound to the diol compound is preferably from 0.8 to 1.2, more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal.

### (ii) Diol compound having at least one carboxyl group

The diol compound having at least one carboxyl group includes diol compounds represented by formulae (5), (6) and (7) shown below and a compound obtained by ring opening of a tetracarboxylic acid dianhydride with a diol compound.

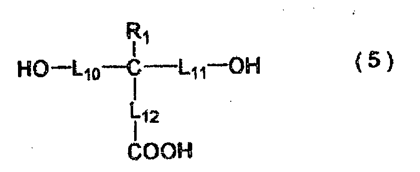

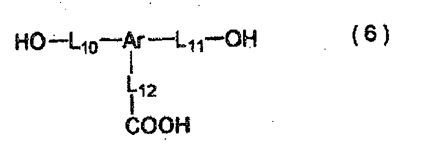

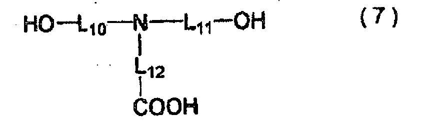

In formulae (5) to (7), R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1 to 10 carbon atoms or an aralkyl group having from 7 to 15 carbon atoms)), preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁, L₁₀, L₁₁ and L₁₂ may be taken together to form a ring. Ar represents a trivalent aromatic hydrocarbon group which may have substituent, preferably an aromatic group having from 6 to 15 carbon atoms.

Specific examples of the diol compound having a carboxyl group represented by formula (5), (6) or (7) include the following compounds.

Specifically, 3,5-dihydraxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionamide are exemplified.

Preferable examples of the tetracarboxylic acid dihydrate, which is used in the preparation of the diol compound having at least one carboxy group, include compounds represented by formulae (8), (9) and (10) shown below.

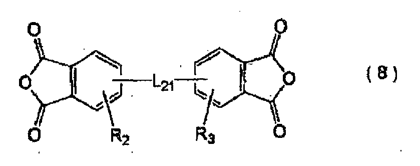

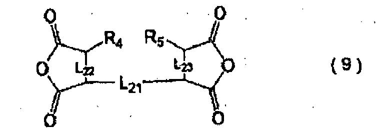

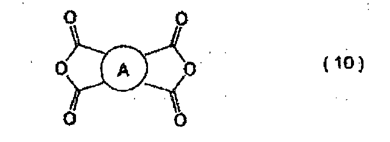

In formulae (8) to (10), L₂₁ represents a single bond, a divalent aliphatic or aromatic hydrocarbon group which may have a substituent (preferably, for example, an alkyl group, an aralkyl group, an aryl group, an alkoxy group, a halogen atom, an ester group or an amido group), -CO-, -SO-, -SO₂-, -O- or -S-, preferably a single bond, a divalent aliphatic hydrocarbon group having from 1 to 15 carbon atoms, -CO-, -SO₂- -O- or -S-. R₂ and R_{3,} which may be the same or different, each represents a hydrogen atom, an alkyl group, an aralkyl group, an aryl group, an alkoxy group or a halogen atom, preferably a hydrogen atom, an alkyl group having from 1 to 8 carbon atoms, an aryl group having from 6 to 15 carbon atoms, an alkoxy group having from 1 to 8 carbon atoms or a halogen atom. Alternatively, two of L₂₁, R₂ and R₃ may be combined with each other to form a ring. R₄ and R₅, which may be the same or different, each represents a hydrogen atom, an alkyl group, an aralkyl group, an aryl group or a halogen atom, preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group, preferably a single bond, a double bond or a methylene group. A represents a monocyclic or polycyclic aromatic ring, preferably an aromatic ring having from 6 to 18 carbon atoms.

Specific examples of the compound represented by formula (8), (9) or (10) include the following compounds.

Specifically, an aromatic tetracarboxylic acid dihydride, for example, pyromellitic acid dihydride, 3,3',4,4-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetracarboxylic acid dihydride, 4,4'-sulfonyldiphthalic acid dihydride, 2,2-bis(3,4-dicarboxyplzenyl)propane dihydride, bis(3,4-dicarboxyphenyl)ether dihydride, 4,4'-[3,3'-(alkylphosphoryldiphenylene)-bis(iminocarbonyl)]diphthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohcxene-1,2-dicarboxylic acid dihydride (Epicron B-4400, produced by Dainippon Ink & Chemicals, Inc.), 1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxyl group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:
a) Method wherein an alcohol-terminated compound obtained by ring-opening of the tetracarboxylic acid dianhydride with a diol compound is reacted with the diisocyanate compound and
b) Method wherein an alcohol-terminated urethane compound obtained by reacting the diisocyanate compound under excess of the diol compound is reacted with the tetracarboxylic acid dianhydride.

Of the diol compounds having at least one carboxyl group, the compounds represented by formula (5) are more preferable because of high solvent solubility and ease of synthesis. The diol compound having at least one carboxyl group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, most preferably from 0.6 to 1.2 meq/g, of the carboxyl group. Therefore, although the content of the structure derived from the diol compound having at least one carboxylic group in the polyurethane resin binder can be appropriately determined after considering a number of the carboxyl group in the diol compound, other diol compound used in combination, an acid value or a molecular weight of the resulting polyurethane resin binder, a composition or pH of developer and the like, it is, for example, ordinarily from 5 to 45% by mole, preferably from 10 to 40% by mole, more preferably from 15 to 35% by mole.

### (iii) Diisocyanate compound having crosslinkable group

The diisocyanate compound having a crosslinkable group includes, for example, a reaction product obtained by an addition reaction of a triisocyanate compound with one equivalent of a monofunctional alcohol or monofunctional amine compound having a crosslinkable group.

Examples of the triisocyanate compound are set forth below, but the invention should not be construed as being limited thereto.

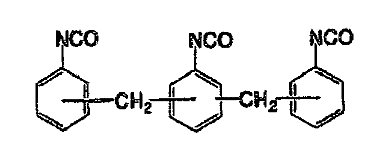

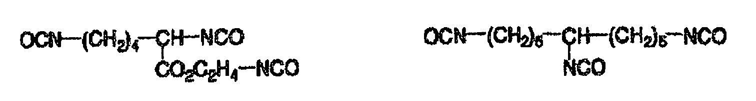

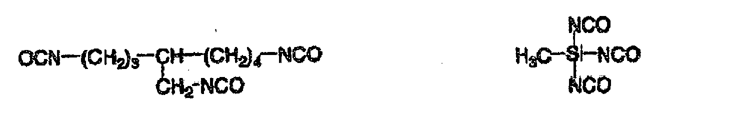

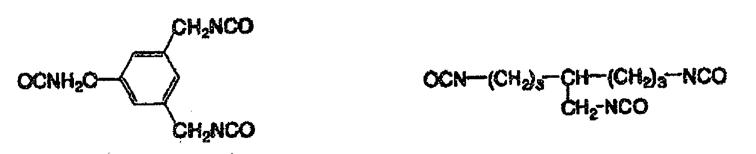

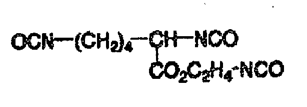

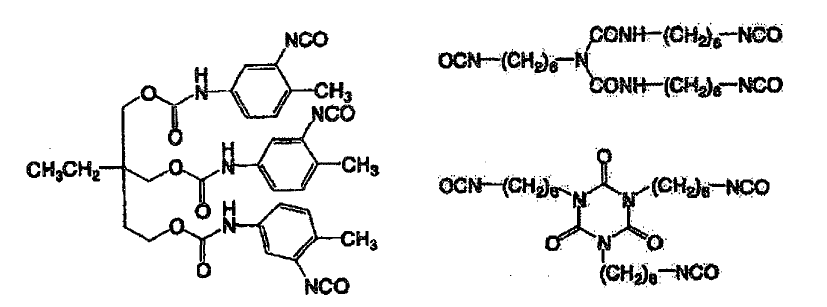

Examples of the monofunctional alcohol or monofunctional amine compound having a crosslinkable group are set forth below, but the invention should not be construed as being limited thereto. 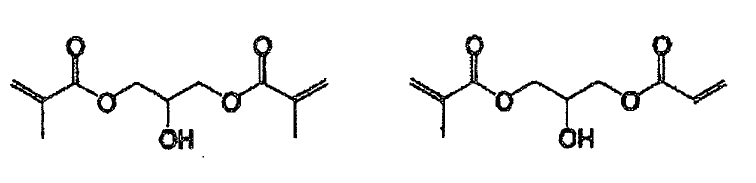 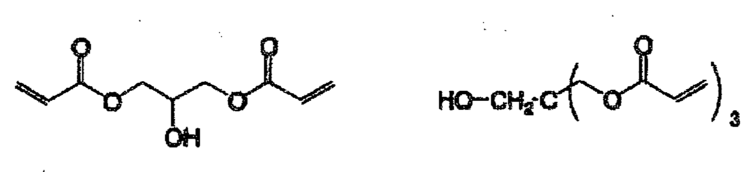 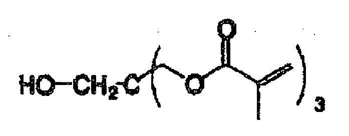 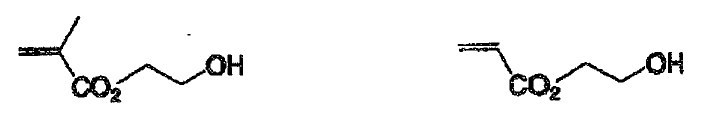 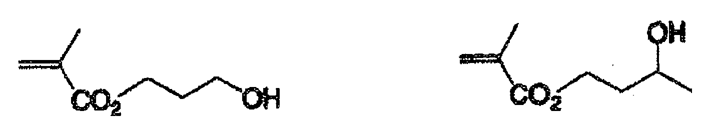 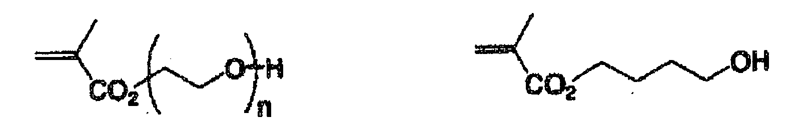 n is an integer of 2 to 10.

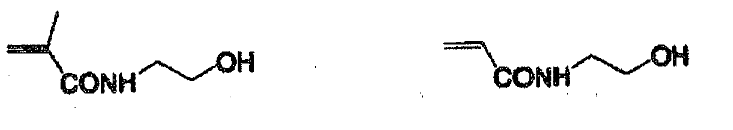

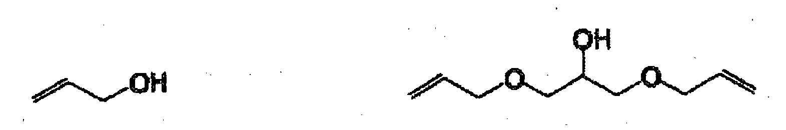

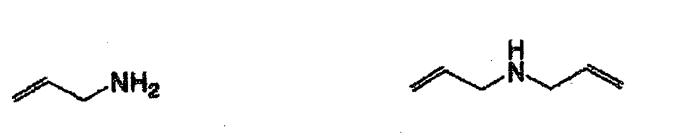

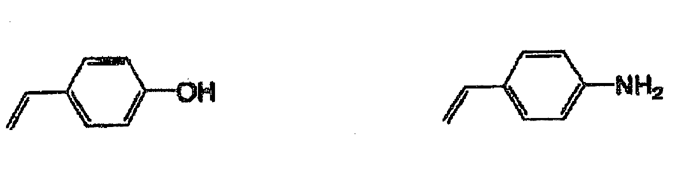

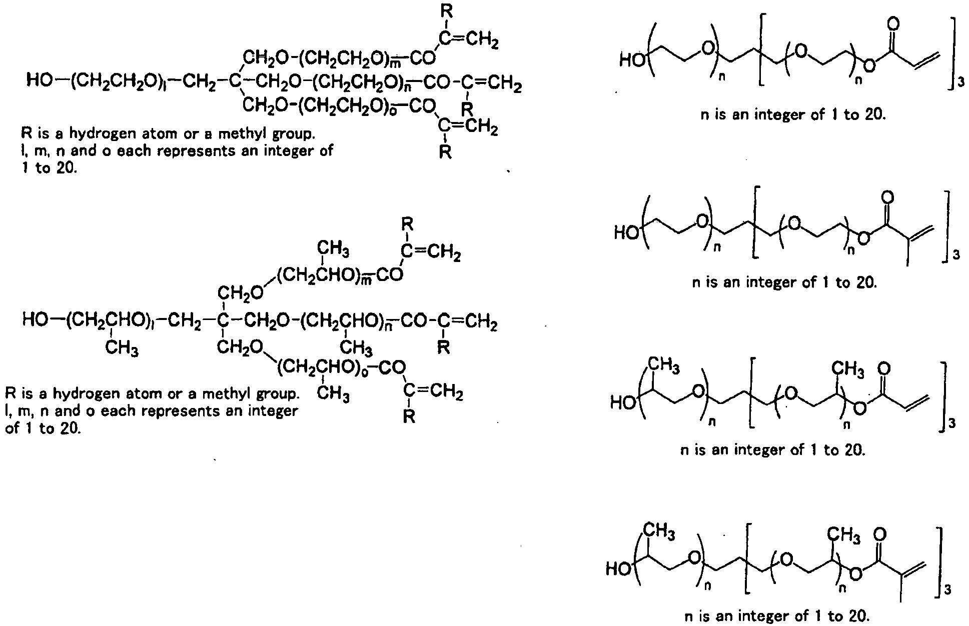

In order to introduce a crosslinkable group into the side chain of the polyurethane resin, a method of using as a raw material for the production of polyurethane resin, the diisocyanate compound having the crosslinkable group in its side chain is preferable. Specific examples of the diisocyanate compound having a crosslinkable group in its side chain obtained by an addition reaction of a triisocyanate compound with one equivalent of a monofunctional alcohol or monofunctional amine compound having the crosslinkable group are set forth below, but the invention should not be construed as being limited thereto.

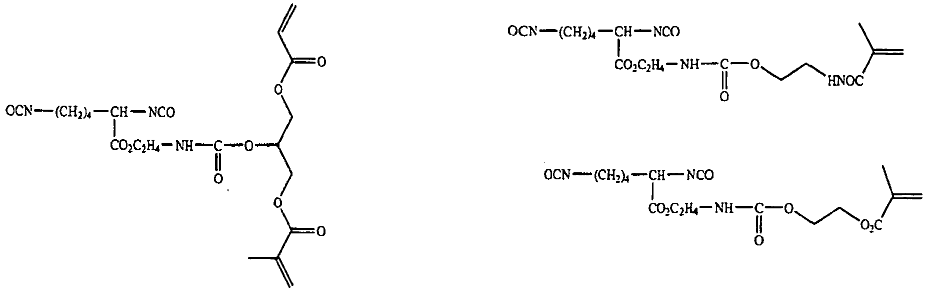

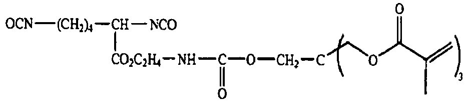

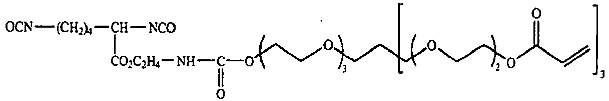

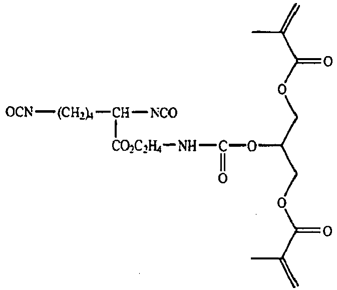

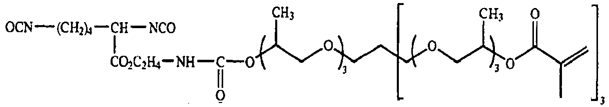

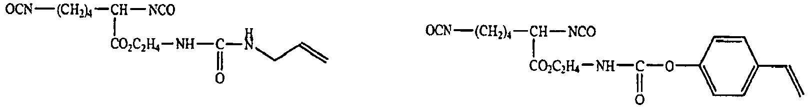

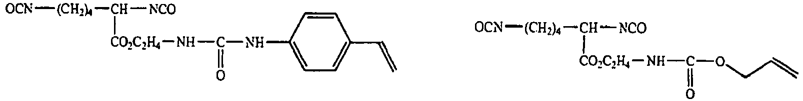

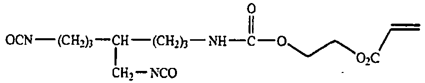

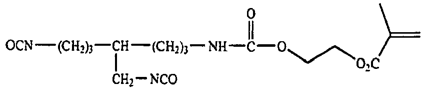

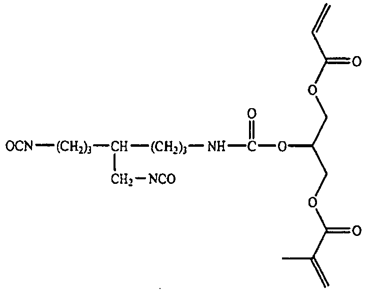

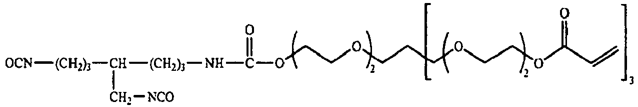

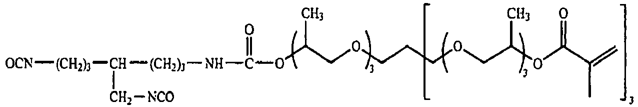

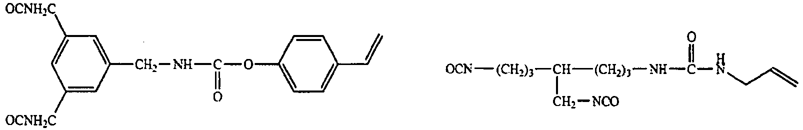

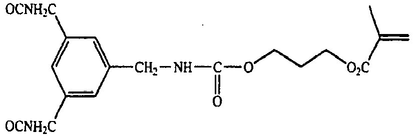

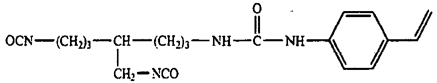

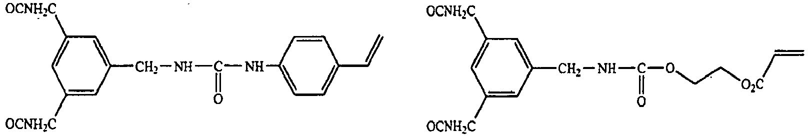

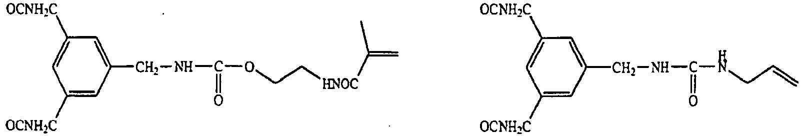

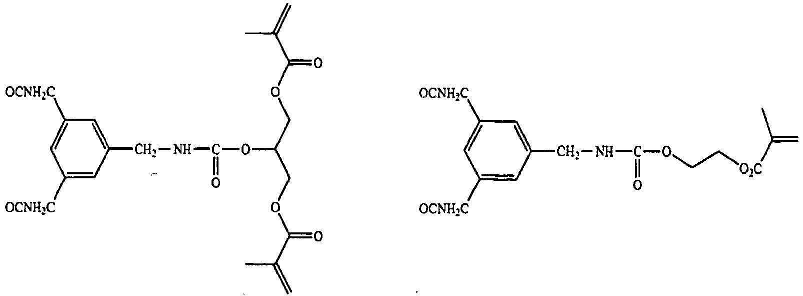

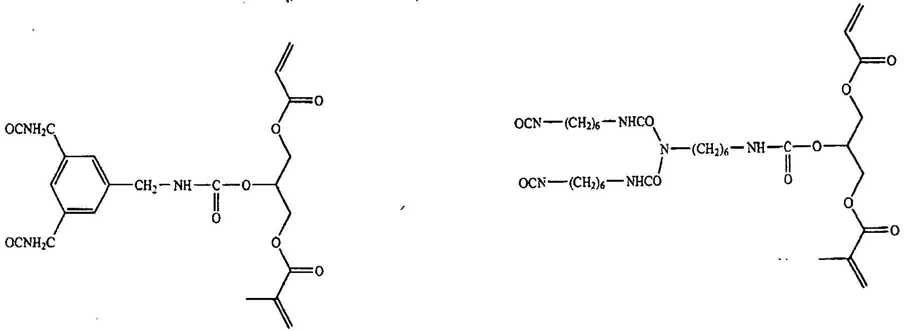

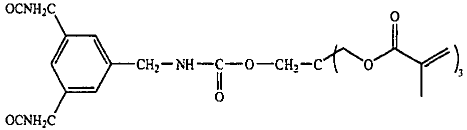

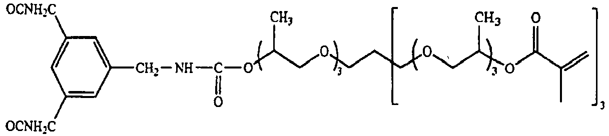

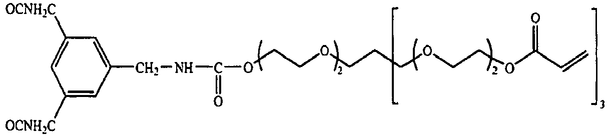

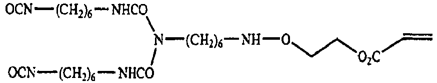

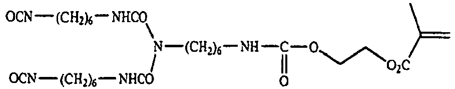

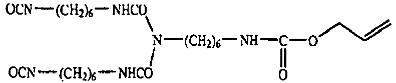

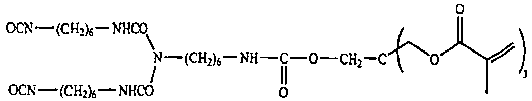

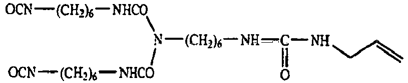

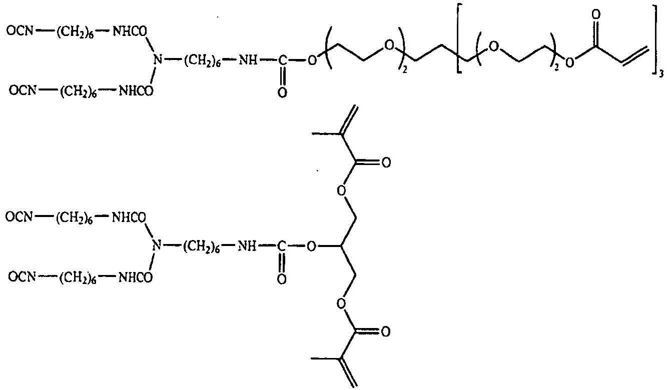

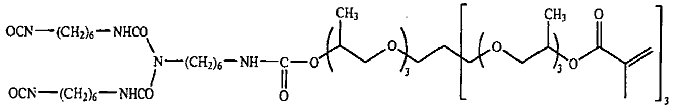

### (iv) Other diol compound

A method of using a diol compound having a crosslinkable group in its side chain as a raw material for the production of polyurethane resin is preferable as well as the method described above for the purpose of introducing the crosslinkable group into the side chain of the polyurethane resin. Such a diol compound may be a commercially available compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound having a crosslinkable group. Specific examples of the diol compound having a crosslinkable group are set forth below, but the invention should not be construed as being limited thereto.

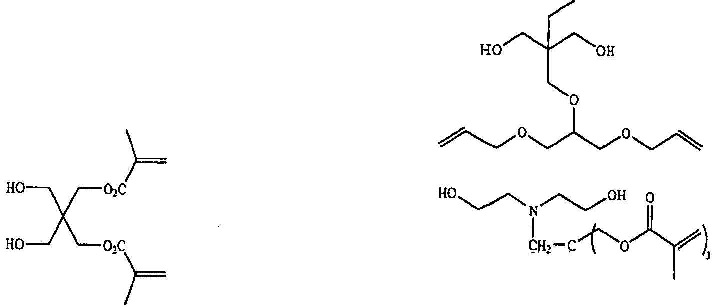

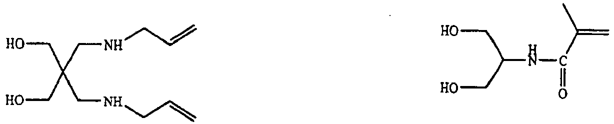

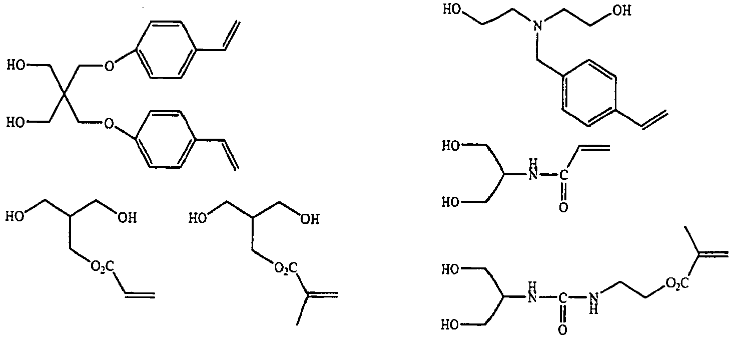

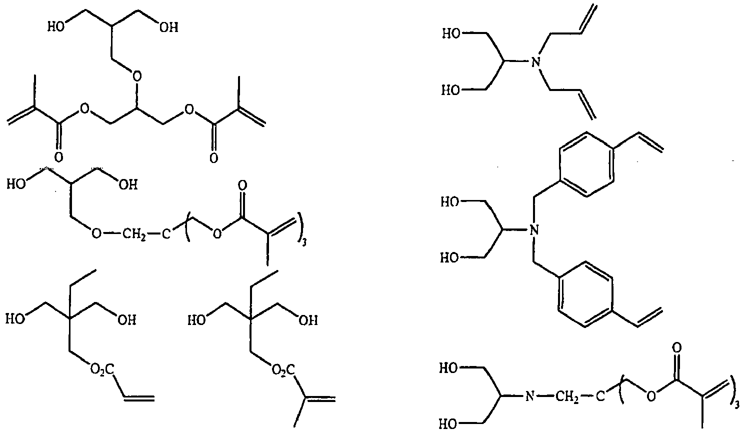

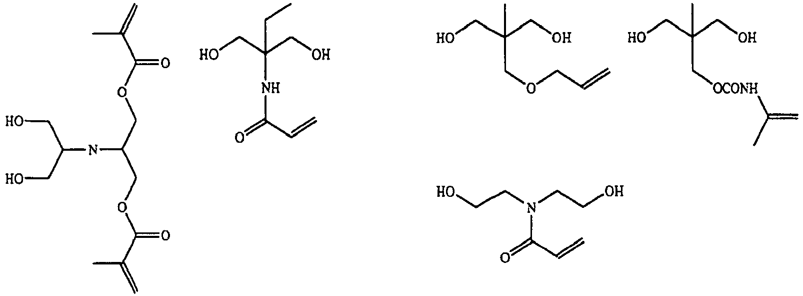

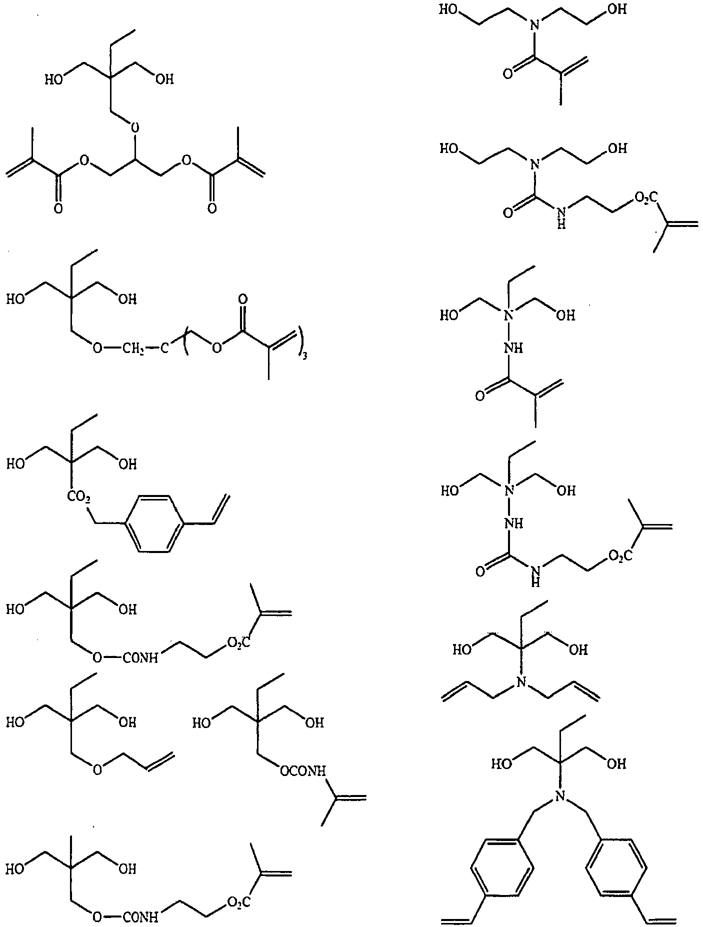

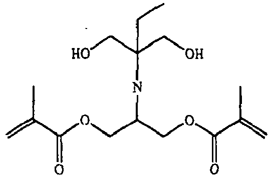

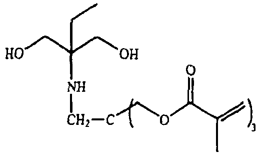

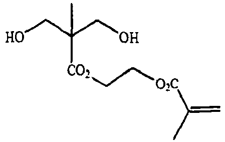

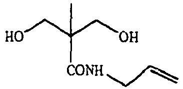

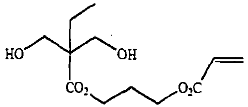

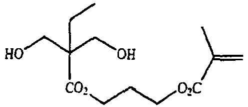

Other examples of the other diol compound include ethylene glycol compounds represented by the following formula (A'):

HO-CH₂CH₂O)*ₙ*-H (A')

In formula (A'), n represents an integer of 1 or more.

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferable in view of the stain resistance. The ethylene glycol compounds represented by formula (A') wherein n is form 2 to 50 are more preferable, those wherein n is form 3 to 30 are still more preferable, and those wherein n is form 4 to 10 are particularly preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by the following formulae (a), (b), (c), (d) and (e) are preferably used.

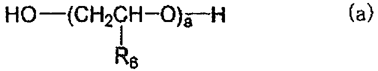

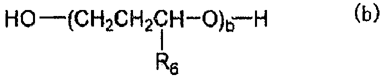

HO-(CH₂CH₂CH₂CH₂-O)_{c}-H (c)

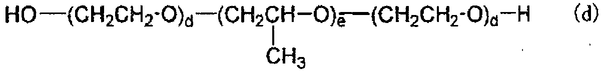

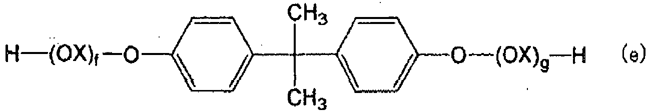

In formulae (a) to (e), R₆ represents a hydrogen atom or a methyl group, provided that R₆ in formula (a) represents a methyl group. X represents a group shown below. 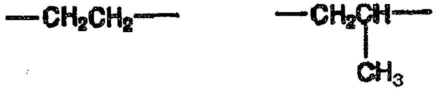 a, b, c, d, e, f and g each represents an integer of 2 or more, and preferably an integer of 2 to 100.

Polyester diol compounds represented by formulae (11) and (12) shown below are also enumerated as specific examples.

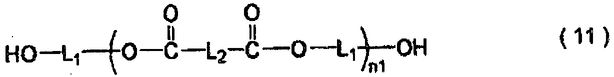

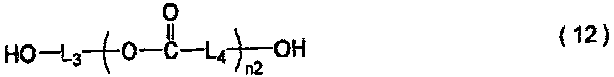

In formulae (11) and (12), L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n1 and n2 each represents an integer of 2 or more, preferably an integer of 2 to 100.

Polycarbonate diol compounds represented by formula (13) shown below are also enumerated as specific examples.

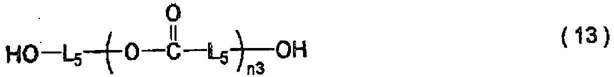

In the formulae (13), L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 represents an integer of 2 or more, preferably an integer of 2 to 100.

Specific examples of the diol compound represented by formula (11), (12) or (13) include those shown below. In the specific examples, n represents an integer of 2 or more.

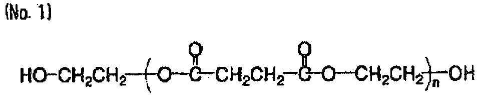

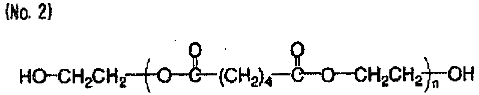

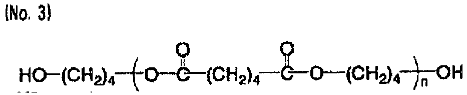

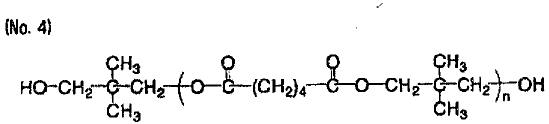

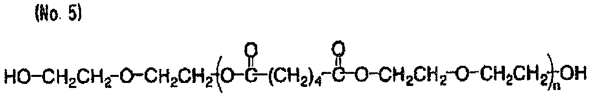

Further, diol compounds shown below are also preferably used.

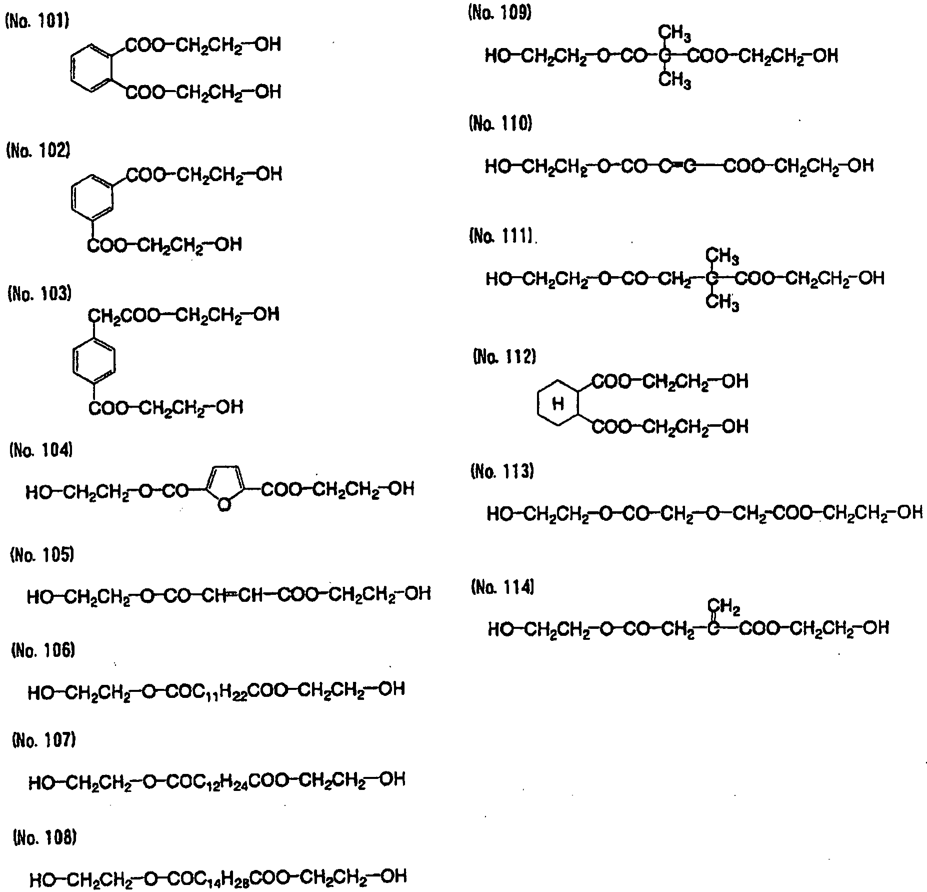

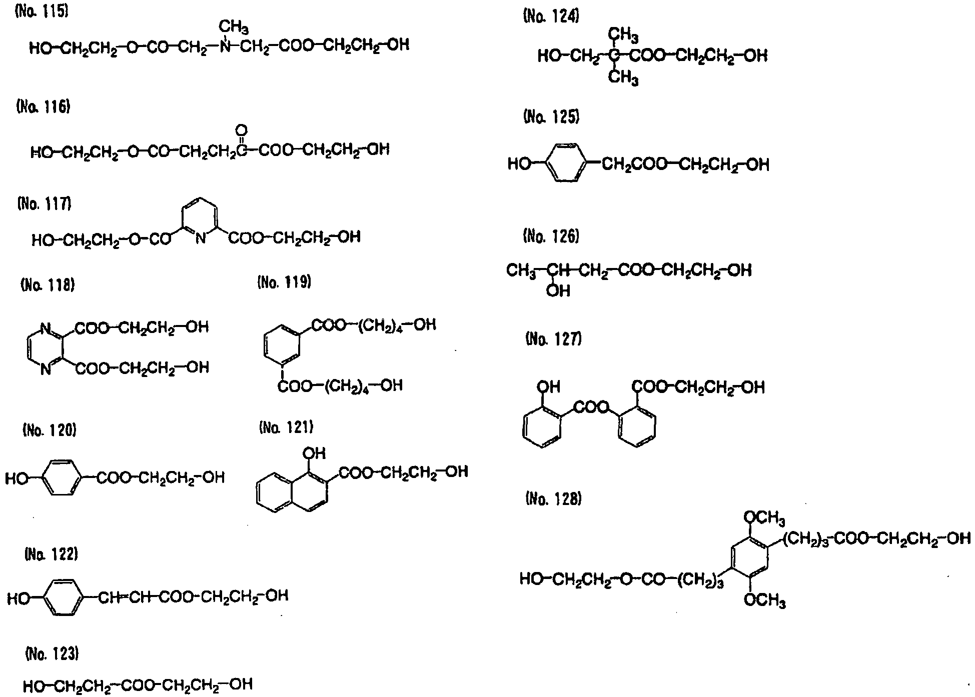

Moreover, diol compounds shown below are also preferably used.

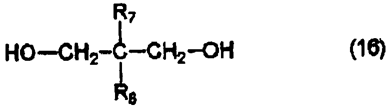

**HO-CH₂-C≡C-CH₂-OH** **(17)**

**HO-CH₂-CH=CH-CH₂-OH** **(18)**

In the formula (16), R₇ and R₈, which may be the same or different, each represents an alkyl group which may have a substituent, preferably an alkyl group having from 1 to 10 carbon atoms which may have a substituent (for example, a cyano group, a nitro group, a halogen atom (e.g., -F,-Cl, -Br or -I), -CONH₂, -COOR or -OR (wherein R, which may be the same or different, each represents an alkyl group having from 1 to 10 carbon atoms, an aryl group having from 7 to 15 carbon atoms or an aralkyl group)).

Specific examples of the diol compound represented by formula (16) include those shown below.

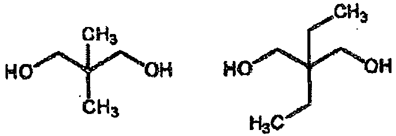

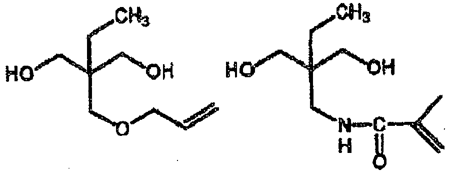

Example of the diol compound represented by formula (17) includes 2-butyne-1,4- diol. Examples of the diol compound represented by formula (18) include cis-2-butene-1,4-diol and trans-2-butene-1,4-diol.

Furthermore, diol compounds represented by formulae (19) and (20) shown below are also preferably used.

HO-L₈-NH-CO-L₉-CO-NH-L₈-OH (19)

HO-L₉-CO-NH-L₈-OH (20)

In formulae (19) and (20), L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl., -Br or -I)). L₈ and L₉ each may have other functional group which does not react with the isocyanate group, for example, a carbonyl group, an ester group, a urethane group, an amido group or a ureido group, if desired. Alternatively, L₈ and L₉ may be combined with each other to form a ring.

Specific examples of the diol compound represented by formula (19) or (20) include those shown below.

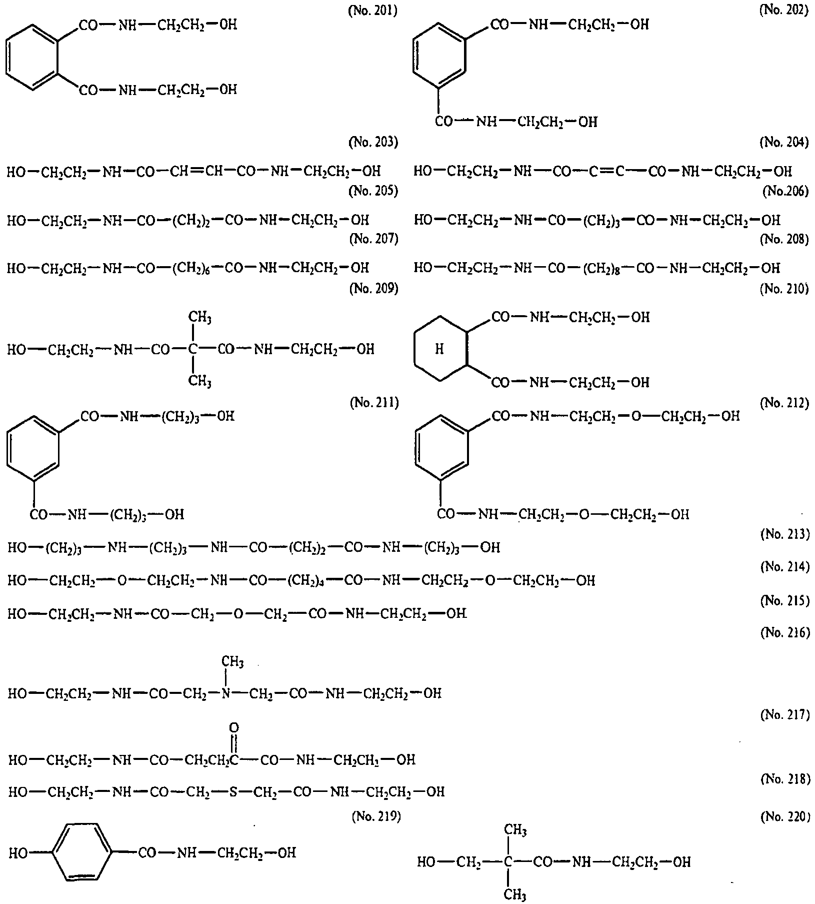

Furthermore, diol compounds represented by formulae (21) and (22) shown below are also preferably used.

HO-Ar₂-(L₁₆-Ar₃)ₙ-OH (21)

HO-Ar₂-L₁₆-OH (22)

In formulae (21) and (22), L1₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms. n represents an integer of 0 to 10.

Specific examples of the diol compound represented by formula (21) or (22) include those shown below.

Specifically, catechol, resorcine, hydroquinone, 4-methylcatechol, 4-tert-butylcatechol, 4-acetylcatechol, 3-methoxycatechol, 4-phenylcatechol, 4-methylresorcine, 4-ethylresorcine, 4-tert-butylresorcine, 4-hexylresorcine, 4-chlororesorcine, 4-benzylresorcine, 4-acetylresorcine, 4-carbomethoxyresorcine, 2-methylresorcine, 5-methylresorcine, tert-butylhydroquinone, 2,5-di-tert-butylhydroquinone, 2,5-di-tert-amythydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybezophenone, 4,4'-dihydroxybiphenyl, 4,4'-thiodiphenol, 2,2'-dihydroxydiphenylmethane, 3,4-bis(p-hydroxyphenyl)hexane. 1,4-bis(2-p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydxoxybezyl alcohol, 2-hydroxy-3,5-di-tert-butylbezyl alcohol, 4-hydroxy-3,5-di-tert--butylbezyl alcohol, 4-hydroxyphenethyl alcohol, 2-hydroxyethyl-4-1-hydroxybenzoate, 2-hydroxyethyl-4-hydroxyphenylacetate and resorcine mono-2-hydroxyethyl ether are exemplified.

### (v) Other amino group-containing compound,

In the polyurethane resin binder according to the invention, an amino group-containing compound represented by formula (31) or (32) shown below may be used together to react with the diisocyanate compound, thereby forming a urea structure to incorporate into the polyurethane resin.

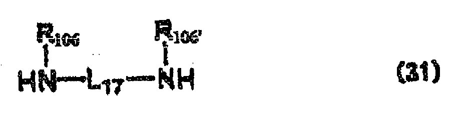

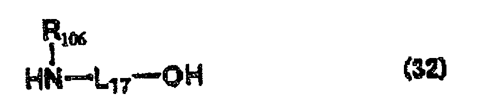

In formulae (31) and (32), R₁₀₆ and R₁₀₆, which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxyl group), preferably a hydrogen atom, an alkyl group having from 1 to 8 carbon atoms or an aryl group having from 6 to 15 carbon atoms, each of which may have a carboxyl group as a substituent. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group, a halogen atom (e.g., -F, -Cl, -Br or -I) or a carboxyl group). L₁₇ may have other functional group which does not react with the isocyanate group, for example, a carbonyl group, an ester group, a urethane group or an amido group, if desired. Alternatively, two of R₁₀₆, L₁₇ and R₁₀₆' may be combined with each other to form a ring.

Specific examples of the compound represented by formula (31) or (32) include the following compounds.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine or isophorondiamine; aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalendiamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptophan or adenine; and aminoalcohol or aminophenol compounds, for example, ethanolamine, N-methylethanolamine, N-ethylethanolamine, 1-amino-2-propanol, 1-amino-3-propanol, 2-aminaethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methaxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenetlayl alcohol, 2-carboxy-5-amino-1-naphthol or L-tyrosine are enumerated.

A polyurethane resin obtained by introducing a crosslinkable group into polyurethane having a carboxyl group by a polymer reaction as described in JP-A-2003-270775 may also be used as the binder polymer according to the invention as well as the above-described polyurethane resin obtained by introducing a crosslinkable group into a side chain at the synthesis of polyurethane.

According to the invention, a combination of a monomer having a melting point of 45°C or more with the urethane resin containing a crosslinkable group described above is particularly preferably used. Specific example of the urethane resin is set forth below, but the invention should not be construed as being limited thereto.

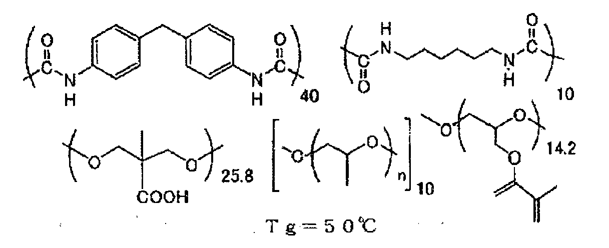

The binder polymer for use in the invention preferably has an appropriate molecular weight in order to maintain the developing property of the photosensitive layer. The weight average molecular weight thereof is preferably in a range of 5,000 to 300,000, and more preferably in a range of 20,000 to 150,000.

Although the binder polymer can be incorporated into the photosensitive layer in an appropriate amount, when the amount of the binder polymer exceeds 90% by weight of the photosensitive layer, a preferable result may not be obtained in view of image strength or the like in some cases. It is preferably from 10 to 90% by weight, and more preferably from 30 to 80% by weight.

### (Chain transfer agent)

The photosensitive layer according to the invention may further contain a chain transfer agent. The chain transfer agent contributes to improvements in the sensitivity and preservation stability. Compounds which function as the chain transfer agents include, for example, compounds containing SH, PH, SiH or GeH in their molecules. Such a compound donates hydrogen to a radical species of low activity to generate a radical, or is oxidized and then deprotonated to generate a radical.

In the photosensitive layer according to the invention, a thiol compound (for example, a 2-mercaptobenzimidazole) is preferably used as the chain transfer agent.

Among them, a thiol compound represented by formula (I) shown below is particularly preferably used. By using the thiol compound represented by formula (I) as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and good printing durability is obtained.

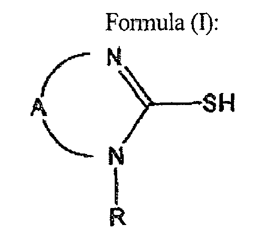

In formula (I), R represents a hydrogen atom, an alkyl group which may have a substituent or an aryl group which may have a substituent, A represents an atomic group necessary for forming a 5-membered or 6-membered hetero ring containing a carbon atom together with the N=C-N linkage, and A may have a substituent.

Compounds represented by formulae (IA) and (IB) shown below are more preferably used.

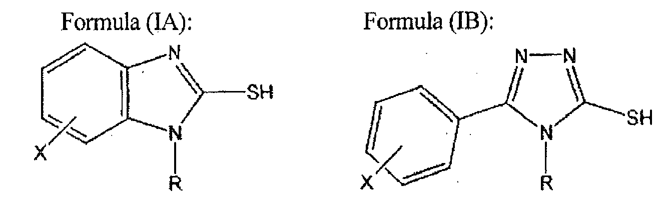

If formulae (IA) and (IB), R represents a hydrogen atom, an alkyl group which may have a substituent or an aryl group which may have a substituent, and X represents a hydrogen atom, a halogen atom, an alkoxy group which may have a substituent, an alkyl group which may have a substituent or an aryl group which may have a substituent.

Specific examples of the compound represented by formula (I) are set forth below, but the invention should not be construed as being limited thereto.

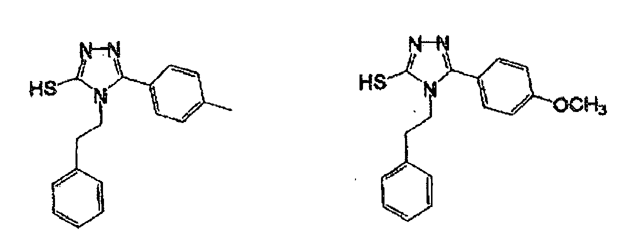

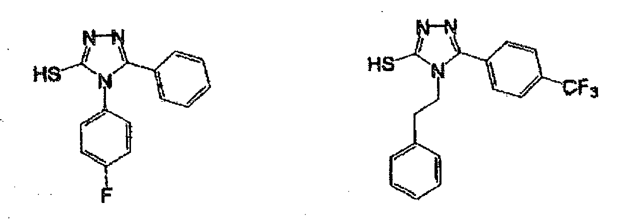

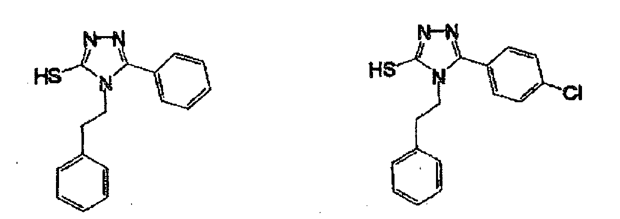

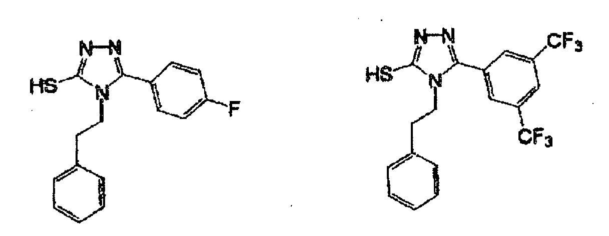

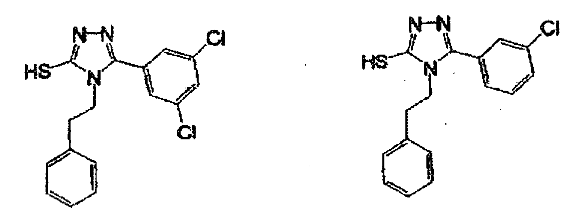

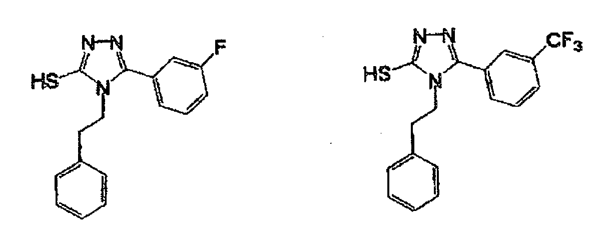

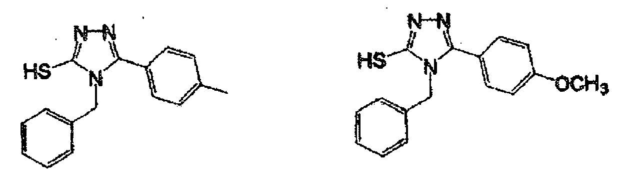

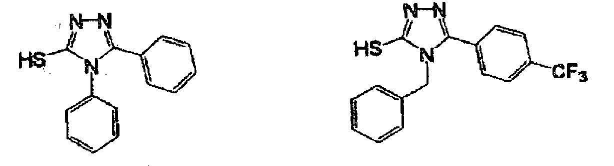

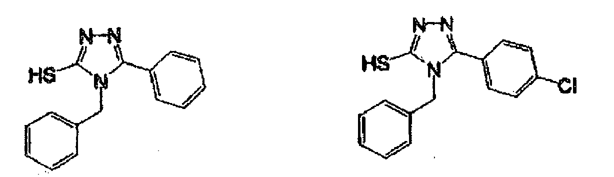

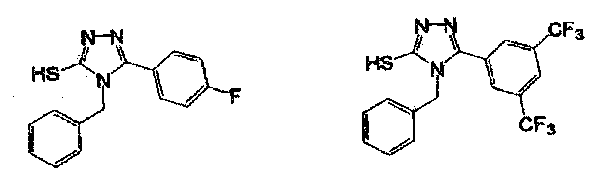

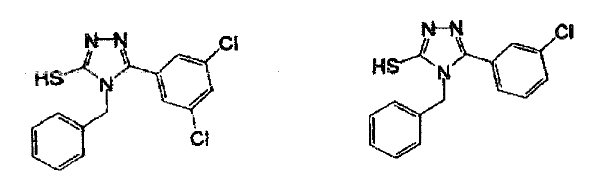

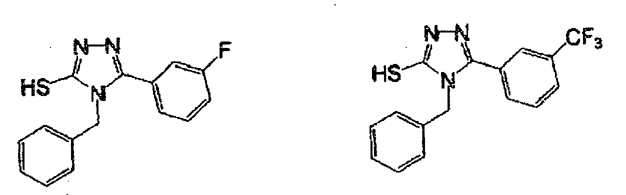

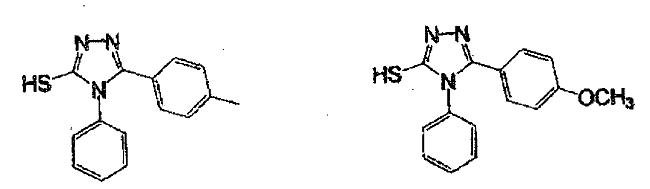

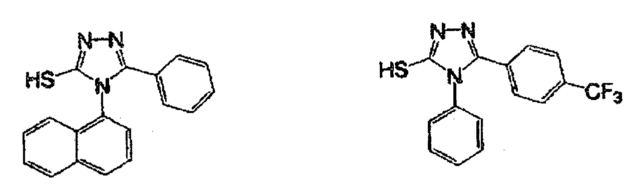

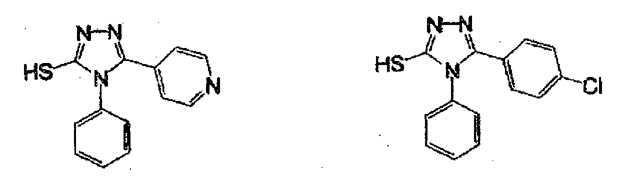

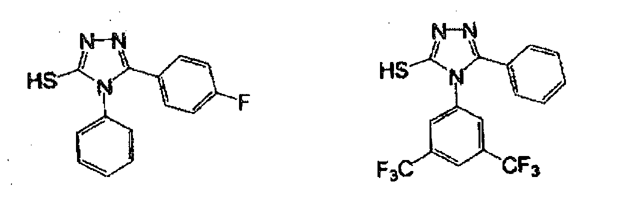

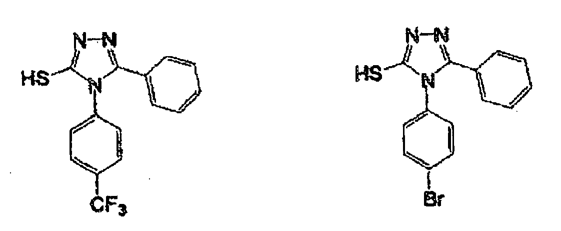

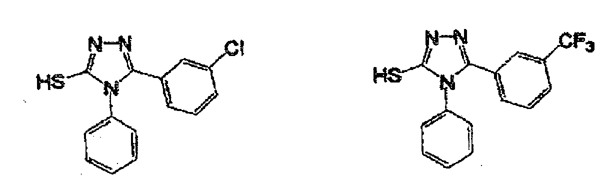

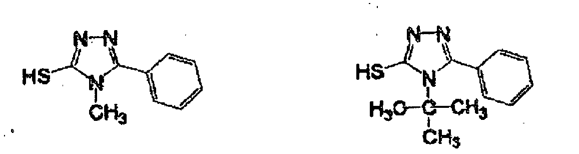

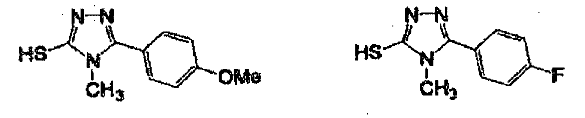

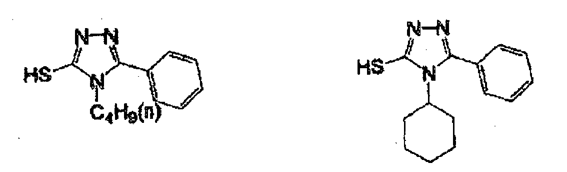

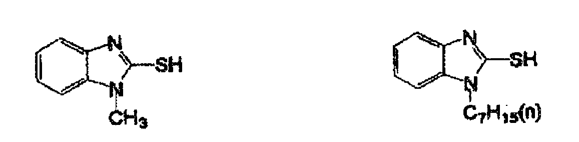

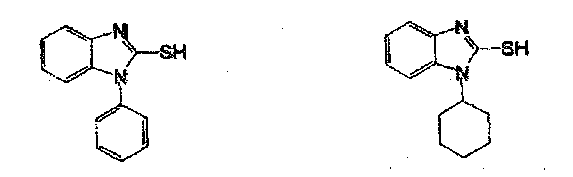

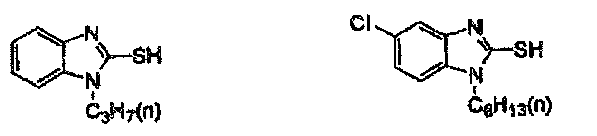

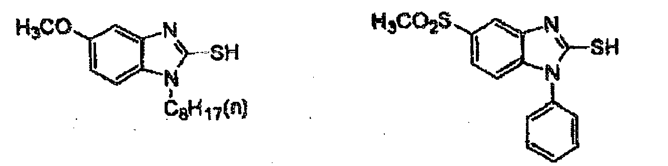

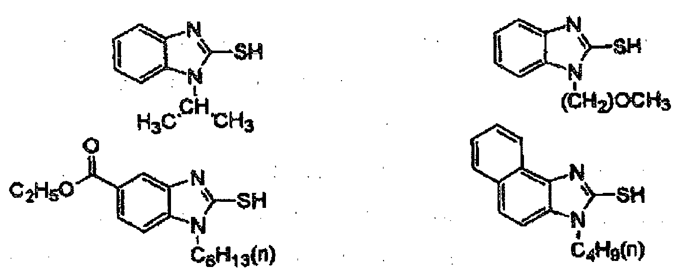

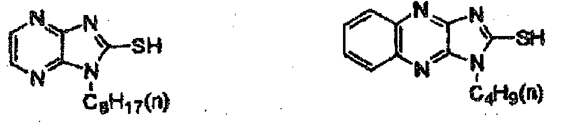

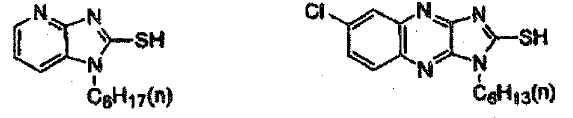

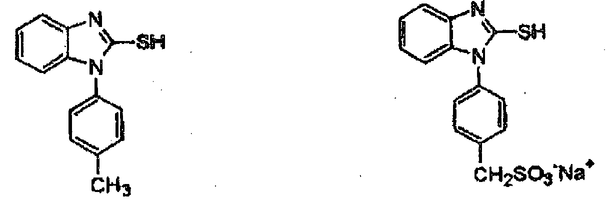

The amount of the chain transfer agent, for example, the thiol compound, used is preferably from 0.01 to 20% by weight, more preferably from 0.1 to 15% by weight, still more preferably from 1.0 to 10% by weight, based on the total solid content of the photosensitive layer.

### (Microcapsule)

In the invention, in order to incorporate the above-described constituting components of the photosensitive layer and other constituting components described hereinafter into the photosensitive layer, a part of the constituting components is encapsulated into microcapsules and added to the photosensitive layer as described, for example, in JP-A-2001-277740 and JP-A-2001-277742. In such a case, each constituting component may be present inside or outside the microcapsule in an appropriate ratio.

As a method of microencapsulating the constituting components of the photosensitive layer, known methods can be used. Methods for the production of microcapsules include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by polymerization of monomer described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.

A preferable microcapsule wall used in the invention has three-dimensional crosslinking and has a solvent-swellable property. From this point of view, a preferable wall material of the microcapsule includes polyurea, polyurethane, polyester, polycarbonate, polyamide and a mixture thereof, and particularly polyurea and polyurethane are preferred. Further, a compound having a crosslinkable functional group, for example, an ethylenically unsaturated bond, capable of being introduced into the binder polymer described above may be introduced into the microcapsule wall.

The average particle size of the microcapsule is preferably from 0.01 to 3.0 µm, more preferably from 0.05 to 2.0 µm, and particularly preferably from 0.10 to 1.0 µm. In the range described above, preferable resolution and good preservation stability can be achieved.

### (Other components of photosensitive layer)

Into the photosensitive layer according to the invention, various additives can be further incorporated, if desired. Examples of the additive include a surfactant for progressing the developing property and improving the state of surface coated, a hydrophilic polymer for improving the developing property and dispersion stability of microcapsule, a coloring agent or print-out agent for visually distinguishing the image area from the non-image area, a polymerization inhibitor for preventing undesirable thermal polymerization of the polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity, and a plasticizer for improving plasticity. As the additives, known compounds can be used. For example, compounds described in JP-A-2007-171406, JP-A-2007-206216, JP-A-2007-206217, JP-A-2007-225701, JP-A-2007-225702, JP-A-2007-316582 and JP-A-2007-328243 are used.

### (Formation of photosensitive layer)

The photosensitive layer according to the invention is formed by dispersing or dissolving each of the necessary components described above to prepare a coating solution and coating the solution on a support. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid concentration of the coating solution is preferably from 1 to 50% by weight.

The photosensitive layer according to the invention may also be formed by preparing plural coating solutions by dispersing or dissolving the same or different components described above into the same or different solvents and conducting repeatedly plural coating and drying.

The coating amount (solid content) of the photosensitive layer on the support after the coating and drying may be varied depending on the use, but ordinarily, it is preferably from 0.3 to 3.0 g/m². In the range described above, the preferable sensitivity and good film property of the photosensitive layer can be obtained.

Various methods can be used for the coating. Examples of the method include bar coater coating, spin coating, spray coating, curtain coating, dip coating, air knife coating, blade coating and roll coating.

### [Protective layer]

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. The protective layer for use in the invention preferably has oxygen permeability (A) at 25°C under one atmosphere of 1.0 ≤ (A) ≤ 20 (ml/m²·day). When the oxygen permeability (A) is extremely lower than 1.0 (ml/m²·day), problems may occur in that an undesirable polymerization reaction arises during the production or preservation before image exposure and in that undesirable fog or spread of image line occurs at the image exposure. On the contrary, when the oxygen permeability (A) greatly exceeds 20 (ml/m²·day), decrease in sensitivity may be incurred. The oxygen permeability (A) is more preferably in a range of 1.5 ≤ (A) ≤ 12 (ml/m²·day), still more preferably in a range of 2.0 ≤ (A) ≤ 10.0 (ml/m²·day). Besides the above described oxygen permeability, as for the characteristics required of the protective layer, it is desired that the protective layer does not substantially hinder the transmission of light for the exposure, is excellent in the adhesion property to the photosensitive layer, and can be easily removed during a development step after the exposure. Contrivances on the protective layer have been heretofore made and described in detail in U.S. Patent 3,458,311 and JP-B-55-49729.

As a binder of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics, for example, oxygen-blocking property and removability of the protective layer by development.

Polyvinyl alcohol for use in the protective layer may be partially substituted with ester, ether or acetal as long as it contains unsubstituted vinyl alcohol units for achieving the necessary oxygen-blocking property and water solubility. Also, a part of polyvinyl alcohol may have other copolymer component. As specific examples of the polyvinyl alcohol, those having a hydrolyzing rate of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferable embodiment, the content of polyvinyl alcohol in the protective layer is from 20 to 95% by weight, and more preferably from 30 to 90% by weight.

Also, known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen-blocking property and removability by development. The content thereof is ordinarily from 3.5 to 80% by weight, preferably from 10 to 60% by weight, more preferably from 15 to 30% by weight, in the protective layer.

The components of the protective layer (selection of PVA and use of additives) and the coating amount are determined taking into consideration fogging property, adhesion property and scratch resistance besides the oxygen-blocking property and removability by development. In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the binder, for example, polyvinyl alcohol (PVA) is ordinarily in a range of 2,000 to 10,000,000, and preferably in a range of 20,000 to 3,000,000.

As other additive of the protective layer, glycerin, dipropylene glycol or the like can be added in an amount corresponding to several % by weight of the binder to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the binder.

The adhesion property of the protective layer to the photosensitive layer and scratch resistance are also extremely important in view of handling of the printing plate precursor. Specifically, when a hydrophilic layer comprising a water-soluble polymer is laminated on the oleophilic photosensitive layer, layer peeling due to an insufficient adhesion property is liable to occur, and the peeled portion causes such a defect as failure in curing of the photosensitive layer due to polymerization inhibition by oxygen. Various proposals have been made for improving the adhesion property between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the photosensitive layer. Any of these known techniques can be applied to the protective layer according to the invention. Coating methods of the protective layer are described in detail, for example, in U.S. Patent 3,458,311 and JP-B-55-49729.

Further, it is also preferred to incorporate an inorganic stratiform compound into the protective layer of the lithographic printing plate precursor according to the invention for the purpose of improving the oxygen-blocking property and property for protecting the surface of photosensitive layer.

The inorganic stratiform compound used here is a particle having a thin tabular shape and includes, for instance, mica, for example, natural mica represented by the following formula: A (B, C)₂₋₅ D₄ O₁₀ (OH, F, O)₂, (wherein A represents any one of K, Na and Ca, B and C each represents any one of Fe (II), Fe(III), Mn, Al, Mg and V, and D represents Si or Al) or synthetic mica; talc represented by the following formula: 3M_{g}O·4SiO·H₂O; teniolite; montmorillonite; saponite; hectolite; and zirconium phosphate.

Of the inorganic stratiform compounds, fluorine based swellable mica, which is a synthetic inorganic stratiform compound, is particularly useful in the invention.

An aspect ratio of the inorganic stratiform compound according to the invention is preferably 20 or more, more preferably 100 or more, and particularly preferably 200 or more. The aspect ratio is a ratio of major axis to thickness of particle and can be determined, for example, from a projection drawing of particle by a microphotography. The larger the aspect ratio, the greater the effect obtained.

As for the particle size of the inorganic stratiform compound for use in the invention, an average major axis is ordinarily from 0.3 to 20 µm, preferably from 0.5 to 10 µm, and particularly preferably from 1 to 5 µm. An average thickness of the particle is ordinarily 0.1 µm or less, preferably 0.05 µm or less, and particularly preferably 0.01 µm or less. For example, in the swellable synthetic mica that is the representative compound of the inorganic stratiform compounds, thickness is approximately from 1 to 50 nm and plain size is approximately from 1 to 20 µm.

When such an inorganic stratiform compound particle having a large aspect ratio is incorporated into the protective layer, strength of coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/100 in terms of weight ratio to the amount of binder used in the protective layer. When a plurality of inorganic stratiform compounds is used in combination, it is also preferred that the total amount of the inorganic stratiform compounds fulfills the above-described weight ratio.

For the dispersion of inorganic stratiform compound used in the protective layer, methods described in JP-A-2007-171406, JP-A-2007-206216, JP-A-2007-206217, JP-A-2007-225701, JP-A-2007-225702, JP-A-2007-316582 and JP-A-2007-328243 are used.

The coating amount of the protective layer is preferably in a range of 0.05 to 10 g/m² in terms of the coating amount after drying. When the protective layer contains the inorganic stratiform compound, it is more preferably in a range of 0.1 to 3 g/m², and when the protective layer does not contain the inorganic stratiform compound, it is more preferably in a range of 0.5 to 5 g/m².

### [Backcoat layer]

A backcoat layer can be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### [Method of preparing lithographic printing plate]

Now, the method of preparing a lithographic printing plate using the lithographic printing plate precursor according to the invention is described in greater detail below. The method of preparing a lithographic printing plate according to the invention comprises a step (exposure step) where the lithographic printing plate precursor is subjected to image exposure and a step (development step) where the exposed lithographic printing plate precursor is subjected to a monobath development processing with a developer. Specifically, in the method of preparing a lithographic printing plate according to the invention, pre-water washing treatment is not conducted before the development step and water washing treatment or treatment (gum treatment) with a gum solution are not conducted after the development step. A step of exposing to light and/or heating the entire surface of lithographic printing plate precursor may be provided between the exposure step and the development step and/or after the development step, if desired. Also, after the development step, a drying step (including natural drying) may be provided.

First, the exposure step is described below. The image exposure of the lithographic printing plate precursor is performed by a method of exposing through a transparent original having a line image, a halftone dot image or the like or a method of scanning of laser beam based on digital data.

A preferable example of the wavelength of light source for use in the image exposure is from 350 to 450 nm.

Specifically, a gas laser, for example, Ar ion laser (364 nm, 351 nm, 10 mW to 1 W), Kr ion laser (356 nm, 351 nm, 10 mW to 1 W) or He-Cd laser (441 nm, 325 nm, 1 mW to 100 mW); a solid laser, for example, a combination ofNd:YAG (YVO₄) with SHG crystalsxtwice (355 nm, 5 mW to 1 W) or a combination of Cr:LiSAF with SHG crystal (430 nm, 10 mW); a semiconductor laser system, for example, a KNbO₃ ring resonator (430 nm, 30 mW), a combination of a waveguide-type wavelength conversion element with an AlGaAs or InGaAs semiconductor (380 to 450 nm, 5 to 100 mW), a combination of a waveguide-type wavelength conversion element with an AlGaInP or AlGaAs semiconductor (300 to 350 nm, 5 to 100 mW), or AlGaInN (350 to 450 nm, 5 to 30 mW); and a pulse laser, for example, N₂ laser (337 nm, pulse 0.1 to 10 mJ) or XeF (351 nm, pulse 10 to 250 mJ) are exemplified. Among the light sources, the AlGaInN semiconductor laser (commercially available InGaN semiconductor laser, 400 to 410 nm, 5 to 30 mW) is particularly preferable in view of the wavelength characteristics and cost.

Another preferable example of the wavelength of light source for use in the image exposure is from 750 to 1,400 nm. Specifically, a solid laser and a semiconductor laser are preferably used. The output of the laser is preferably 100 mW or more. In order to shorten the exposure time, it is preferred to use a multibeam laser device. The exposure time per pixel is preferably within 20 microseconds. The irradiation energy on the lithographic printing plate precursor is preferably from 10 to 300 mJ/cm². When the energy for exposure is too low, curing of the photosensitive layer proceeds insufficiently. When the energy for exposure is too high, the photosensitive layer undergoes laser ablation, resulting in damage to the image in some cases.

In the image exposure according to the invention, light beams of the light source can be overlapped to perform exposure. The term "overlap'' as used herein means that a pitch width of vertical scanning is smaller than a beam diameter. For example, when the beam diameter is represented by a half-value width of beam intensity (FWHM), the overlap can be quantitatively expressed by FWHM/pitch width of vertical scanning (overlap coefficient). According to the invention, the overlap coefficient is preferably 0.1 or more.

As for the exposure apparatus for the lithographic printing plate precursor of scanning exposure system, the exposure mechanism may be any of an internal drum system, an external drum system and a flat bed system. As the light source, among the light sources described above, those capable of conducting continuous oscillation can be preferably utilized.

Other examples of the exposure light source which can be used in the invention include an ultra-high pressure mercury lamp, a high pressure mercury lamp, a medium pressure mercury lamp, a low pressure mercury lamp, a chemical lamp, a carbon arc lamp, a xenon lamp, a metal halide lamp, various visible or ultraviolet laser lamps, a fluorescent lamp, a tungsten lamp and sunlight.

Next, the development step is described below. In the method of preparing a lithographic printing plate according to the invention, the development is performed by a monobath development processing. The developer for use in the monobath development processing according to the invention is an aqueous solution having a developing action and a pH of from 2 to 11.

Into the developer for use in the invention, a pH buffer agent and a surfactant are incorporated.

The pH buffer agent includes an alkaline buffer agent, for example, (a) a carbonate ion and a hydrogen carbonate ion, (b) a borate ion, (c) an ion of a water-soluble amine compound, and combinations thereof are illustrated. Using the buffer agent, the developer exhibits a pH buffer function and is prevented from fluctuation of the pH even when it is used for a long period of time. As a result, the deterioration of developing property resulting from the fluctuation of pH, the occurrence of development scum and the like are restrained. The combination of a carbonate ion and a hydrogen carbonate ion is particularly preferable.
(a) In order for a carbonate ion and a hydrogen carbonate ion to be present in a developer, a carbonate and a hydrogen carbonate may be added to the developer or a carbonate ion and a hydrogen carbonate ion may be generated by adding a carbonate or a hydrogen carbonate to a developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.
(b) In order for a borate ion to be present in a developer, a boric acid or a borate is added to a developer and then pH of the developer is adjusted using an alkali or an alkali and an acid to generate an appropriate amount of the borate ion.

The boric acid or a borate used is not particularly restricted. The boric acid includes, for example, ortho boric acid, metha boric acid and tetra boric acid, and preferably ortho boric acid and tetra boric acid. The borate includes an alkali metal salt thereof and an alkaline earth metal salt thereof, specifically, an orthoborate, a diborate, a methaborate, a tetraborate, a pentaborate and an octaborate, preferably an orthoborate and a tetraborate, and particularly preferably an alkali metal salt of tetraborate. The alkali metal salt of tetraborate includes, for example, sodium tetraborate, potassium tetraborate and lithium tetraborate, and particularly preferably sodium tetraborate. The borates may be used individually or in combination of two or more thereof.

As the boric acid and borate for use in the invention, ortho boric acid, tetra boric acid and sodium tetraborate are particularly preferable. The boric acid and borate may be used in combination in the developer.
(c) An ion of a water-soluble amine compound may be generated in an aqueous solution of the water-soluble amine compound. To the aqueous solution of water-soluble amine compound may be added an alkali or an acid. Alternatively, the ion of a water-soluble amine compound may be contained in an aqueous solution by adding a compound which is a salt of amine compound per se.

The water-soluble amine compound is not particularly restricted and preferably a water-soluble amine compound having a group capable of facilitating water-solubility. The group capable of facilitating water-solubility includes, for example, a carboxylic acid group, a sulfonic acid group, a sulfinic acid group, a phosphonic acid group and a hydroxy group. The water-soluble amine compound may have two or more groups capable of facilitating water-solubility.

In case where the water-solubility of the water-soluble amine compound is facilitated with a carboxylic acid group, a sulfonic acid group, a sulfinic acid group or a phosphonic acid group, the water-soluble amine compound corresponds to an amino acid. The amino acid is held in equilibrium in an aqueous solution and for example, when the acid group is a carboxylic acid group, the equilibrium state is indicated as below. In the invention, the amino acid means State B shown below and an amino acid ion means State C shown below. A counter ion in State C is preferably a sodium ion or a potassium ion.

Equilibrium of amino acid (case wherein acid group is carboxylic acid group) 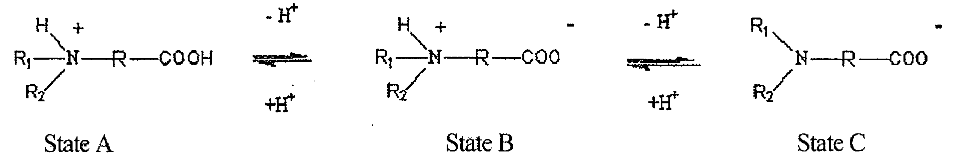 wherein, for example, R₁ and R₂ each independently represents a hydrogen atom, an alkyl group or an aryl group, and R represents a connecting group.

Specific examples of the water-soluble amine compound having a carboxylic acid group, a sulfonic acid group or a sulfinic acid group include an amino acid, for example, glycine, iminodiacatic acid, lysine, threonine, serine, asparaginic acid, parahydroxyphenyl glycine, dihydroxyethyl glycine, alanine, anthranilic acid or tryptophan, sulfamic acid, cyclohexylsulfamic acid, an aliphatic amine sulfonic acid, for example, taurine, and an aliphatic amine sulfinic acid, for example, aminoethanesulfinic acid. Among them, glycine and iminodiacetic acid are preferable.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid and ethylenediaminopentamethylenephosphonic acid. Particularly, 2-aminoethylphosphonic acid is preferable.

The water-soluble amine compound having a hydroxy group as the group capable of facilitating water-solubility means an alkylamine (State B shown below) having a hydroxy group in its alkyl group and its ion means an ammonium ion (State A shown below) of the amino group. 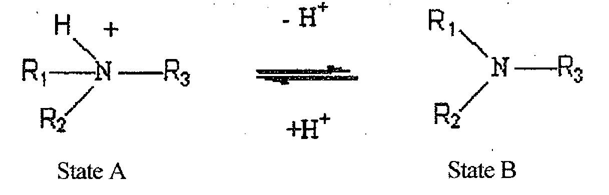 wherein, for example, R₁, R₂ and R₃ each independently represents a hydrogen atom, an alkyl group or an aryl group, provided that at least one of R₁, R₂ and R₃ represents an alkyl group having a hydroxy group.

Examples of the water-soluble amine compound having a hydroxy group include monoethanol amine, diethanol amine, trimethanol amine, triethanol amine, tripropanol amine and triisopropanol amine. Among them, triethanol amine and diethanol amine are preferable. A counter ion of the ammonium group is preferably a chloride ion.

The alkali for use in the adjustment of pH includes, for example, sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, an organic alkali agent and combinations thereof. The acid for use in the adjustment of pH includes, for example, an inorganic acid, for example, hydrochloric acid, sulfuric acid or a nitric acid. By adding such an alkali or acid, the pH can be finely adjusted.

The developer containing a buffer agent for use in the invention preferably has pH in a range of 8.5 to 10.8. When the pH is 8.5 or higher, the developing property in the non-image area is well maintained. On the other hand, when the pH is 10.8 or lower, the developer is hardly affected by carbon dioxide in the atmosphere and degradation of the processing ability due to the influence of carbon dioxide can be prevented. The pH of the developer is more preferably in a range of 8.8 to 10.2, and particularly preferably in a range of 9.0 to 10.0.

When the combination of (a) a carbonate ion and a hydrogen carbonate ion is adopted as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, in the developer. When the total amount is 0.05 mole/l or more, developing property and processing ability are not degraded. When the total amount is 5 mole/l or less, precipitates and crystals hardly generate and since gelation at neutralization of waste liquid of the developer hardly occur, treatment of the waste liquid can be carried out without trouble.

When (b) a borate ion is adopted as the pH buffer agent, the total amount of the borate ion is preferably from 0.05 to 5 mole/l, more preferably from 0.1 to 2 mole/l, particularly preferably from 0.2 to 1 mole/l, in the developer. When the total amount of borate ion is 0.05 mole/l or more, developing property and processing ability are not degraded. On the other hand, when the total amount of borate ion is 5 mole/l or less, precipitates and crystals hardly generate and since gelation at neutralization of the waste liquid hardly occur, treatment of the waste liquid can be carried out without trouble.

When (c) an ion of a water-soluble amine compound is adopted as the pH buffer agent, the total amount of the ion of water-soluble amine compound is preferably from 0.01 to 1 mole/l, more preferably from 0.03 to 0.7 mole/l, particularly preferably from 0.05 to 0.5 mole/l, in the developer. When the total amount of ion of water-soluble amine compound is in the range described above, developing property and processing ability are not degraded and treatment of the waste liquid can be easily carried out.

For the purpose of finely adjusting the alkali concentration or aiding dissolution of the photosensitive layer in the non-image area, an alkali agent, for example, an organic alkali agent may be supplementarily used together. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, 4-(2-hydroxyethyl)morpholine and tetramethylammonium hydroxide. The supplementary alkali agents may be used individually or in combination of two or more thereof.

The surfactant used in the developer for use in the invention may be any of anionic, nonionic, cationic and amphoteric surfactants.

The anionic surfactant is not particularly limited and conventionally known anionic surfactants can be used. Examples of the anionic surfactant include fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer, naphthalene sulfonate formalin condensates, aromatic sulfonic acid salts and aromatic substituted polyoxyethylene sulfonic acid salts. Of the compounds, dialkylsulfosuccinic acid salts, alkyl sulfate ester salts and alkylnaphthalenesulfonic acid salts are particularly preferably used.

The cationic surfactant is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant is not particularly limited and conventionally known nonionic surfactants can be used. Examples of the nonionic surfactant include polyethylene glycol type higher alcohol ethylene oxide addacts, alkylphenol ethylene oxide addacts, polyethylene glycol adducts of aromatic compound, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

In the invention, polyethylene glycol type higher alcohol ethylene oxide addacts, polyethylene glycol adducts of aromatic compound, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant, the HLB (hydrophile-lipophile balance) value thereof is preferably 6 or more, and more preferably 8 or more. Furthermore, an oxyethylene adduct of acetylene glycol type or acetylene alcohol type or a surfactant, for example, a fluorine-based surfactant or a silicon-based surfactant can also be used.

The amphoteric surfactant is a compound having an anionic site and a cationic site in its molecule as well known in the field of surfactant and includes, for example, amphoteric surfactants of amino acid type, betain type and amine oxide type. As the amphoteric surfactant used in the developer for use in the invention, a compound represented by formula <1> shown below or a compound represented by formula <2> shown below is preferable.

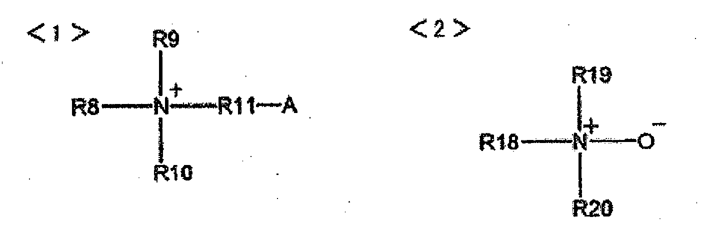

In formula <1>, R8 represents an alkyl group, R9 and R10 each represents a hydrogen atom or an alkyl group, R11 represents an alkylene group, and A represents a carboxylate ion or a sulfonate ion.

In formula <2>, R18, R19 and R20 each represents a hydrogen atom or an alkyl group, provided that all of R18, R19 and R20 are not hydrogen atoms at the same time.

In formula <1>, the alkyl group represented by R8, R9 or R10 or the alkylene group represented by R11 may be a straight chain or branched structure, may contain a connecting group in the chain thereof and may have a substituent. As the connecting group, a connecting group containing a hetero atom, for example, an ester bond, an amido bond or an ether bond is preferable. As the substituent, a hydroxy group, an ethylene oxide group, a phenyl group, an amido group or a halogen atom is preferable.

In the compound represented by formula <1>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some cases. Therefore, the total number of carbon atoms included in R8 to R11 in formula <1> is preferably from 8 to 25, and more preferably from 11 to 21.

In formula <2>, the alkyl group represented by R18, R19 or R20 may be a straight chain or branched structure, may contain a connecting group in the chain thereof and may have a substituent. As the connecting group, a connecting group containing a hetero atom, for example, an ester bond, an amido bond or an ether bond is preferable. As the substituent, a hydroxy group, an ethylene oxide group, a phenyl group, an amido group or a halogen atom is preferable.

In the compound represented by formula <2>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some cases. Therefore, the total number of carbon atoms included in R18 to R20 in formula <2> is preferably from 8 to 22, and more preferably from 10 to 20.

The total number of carbon atoms in the amphoteric surfactant may be influenced depending on property of the materials used in the photosensitive layer, especially, a binder polymer. When the binder polymer having high hydrophilicity is used, it tends to be preferable that the total number of carbon atoms is relatively small. On the other hand, when the binder having low hydrophilicity is used, it tends to be preferable that the total number of carbon atoms is relatively large.

Preferable specific examples of the amphoteric surfactant for use in the developer are set forth below, but the invention should not be construed as being limited thereto.

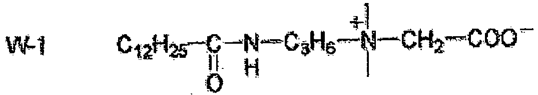

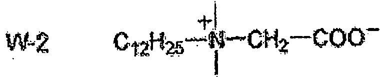

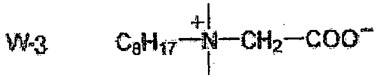

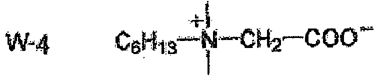

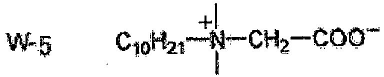

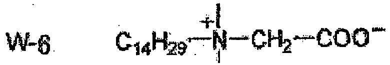

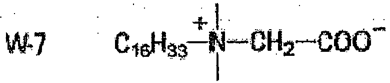

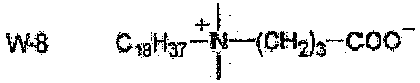

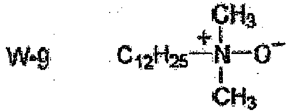

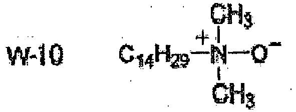

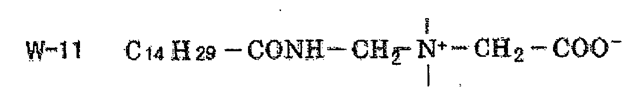

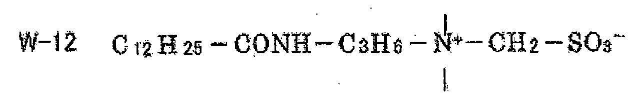

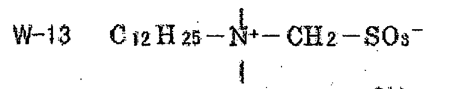

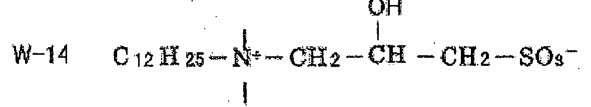

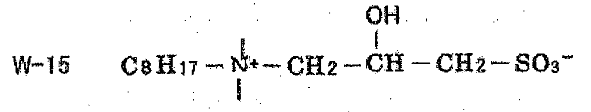

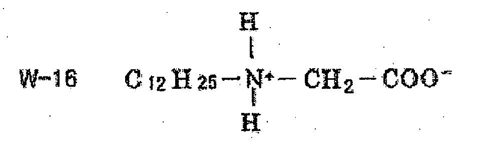

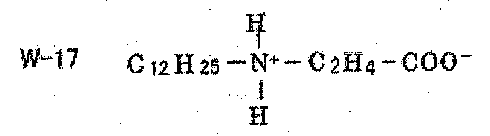

The surfactants may be used individually or in combination of two or more thereof. The content of the surfactant in the developer is preferably from 0.01 to 10% by weight, and more preferably from 0.01 to 5% by weight.

The developer for use in the invention may contain a wetting agent, an antiseptic agent, a chelating agent, a defoaming agent, an organic solvent, an inorganic acid, an inorganic salt, a water-soluble resin or the like in addition the components described above.

As the wetting agent, for example, ethylene glycol, propylene glycol, triethylene glycol, butylene glycol, hexylene glycol, diethylene glycol, dipropylene glycol, glycerin, trimethylol propane or diglycerin is preferably used. The wetting agents may be used individually or in combination of two or more thereof. The wetting agent is ordinarily used in an amount of 0.1 to 5% by weight based on the total weight of the developer.

As the antiseptic agent, for example, phenol or a derivative thereof, formalin, an imidazole derivative, sodium dehydroacetate, a 4-isothiazolin-3-one derivative, benzisotiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative or a nitrobromoalcohol-based compound, e.g., 2-bromo-2-nitropropane-1,3-diol, 1,1-dibromo-1-nitro-2-ethanol or 1,1-dibromo-1-nitro-2-propanol is preferably used. It is preferred to use two or more kinds of the antiseptic agents so as to exert the effect to various molds and bacteria. The amount of the antiseptic agent added is an amount stably exerts the effect to bacterium, molds, yeast or the like. Although the amount of the antiseptic agent may be varied depending on the kind of the bacterium, molds, yeast or the like, it is preferably in a range of 0.01 to 4% by weight based on the developer.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof, aminotri(methylenephosphonic acid), potassium salt thereof, sodium salt thereof; and phosphonoalkanetricarboxylic acids are illustrated. A salt of an organic amine is also effectively used in place of the sodium salt or potassium salt in the chelating agent. The chelating agent is so selected that it is stably present in the developer and does not impair the printing property. The amount of the chelating agent added is preferably from 0.001 to 1.0% by weight based on the developer.

As the defoaming agent, for example, a conventional silicone-based self-emulsifying type or emulsifying type defoaming agent, or a nonionic compound having HLB of 5 or less is used. The silicone defoaming agent is preferably used. Any of emulsifying dispersing type and solubilizing type can be used. The amount of the defoaming agent added is preferably from 0.001 to 1.0% by weight based on the developer.

As the organic solvent, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

As the inorganic acid or inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate or nickel sulfate is illustrated. The amount of the inorganic acid or inorganic salt added is preferably from 0.01 to 0.5% by weight based on the total weight of the developer.

As the water-soluble resin, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer or a styrene/maleic anhydride copolymer is exemplified. An acid value of the water-soluble resin is preferably from 0 to 3.0 meq/g.

As the soybean polysaccharide, those conventionally known can be used. For example, as a commercial product, Soyafive (produced by Fuji Oil Co., Ltd.) is available and various grade products can be used. The soybean polysaccharide preferably used has viscosity in a range of 10 to 100 mPa/sec in a 10% by weight aqueous solution thereof.

As the modified starch, that represented by formula (M) shown below is exemplified. As a starch used for the production of the modified starch, any starch, for example, of corn, potato, tapioca, rice or wheat can be used. The modification of starch can be performed, for example, by a method wherein starch is decomposed, for example, with an acid or an enzyme to an extent that the number of glucose residue per molecule is from 5 to 30 and then oxypropylene is added thereto in an alkali.

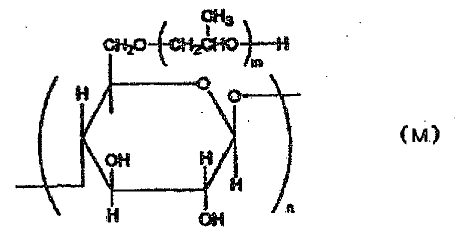

In formula (M), the etherification degree (substitution degree) is in a range of 0.05 to 1.2 per glucose unit, n represents an integer of 3 to 30, and m represents an integer of 1 to 3.

Other examples of the modified starch and the derivative thereof include roast starch, for example, British gum, an enzymatically modified dextrin, for example, enzyme dextrin or Shardinger dextrin, oxidized starch, for example, solubilized starch, alphalized starch, for example, modified alphalized starch or unmodified alphalized starch, esterified starch, for example, starch phosphate, starch of fatty acid, starch sulfate, starch nitrate, starch xanthate or starch carbamate, etherified starch, for example, carboxyalkyl starch, hydroxyalkyl starch, sulfoalkyl starch, cyanoethyl starch, allyl starch, benzyl starch, carbamylethyl starch or dialkylamino starch, cross-linked starch, for example, methylol cross-linked starch, hydroxyalkyl cross-linked starch, phosphoric acid cross-linked starch or dicarboxylic acid cross-linked starch, and starch graft copolymer, for example, starch-polyacrylamide copolymer, starch-polyacrylic acid copolymer, starch-polyvinyl acetate copolymer, starch-polyacrylonitrile copolymer, cationic starch-polyacrylate copolymer, cationic starch-vinyl polymer copolymer, starch-polystyrene-maleic acid copolymer, starch-polyethylene oxide copolymer or starch-polypropylene copolymer.

Of the water-soluble resins, for example, soybean polysaccharide, modified starch, gum arabic, dextrin, carboxymethyl cellulose or polyvinyl alcohol is preferable.

The water-soluble resins may be used in combination of two or more. The content of the water-soluble resin is preferably from 0.1 to 20% by weight, more preferably from 0.5 to 10% by weight, based on the developer.

The temperature of developer is ordinarily 60°C or lower, and preferably from about 15 to about 40°C.

In the method of preparing a lithographic printing plate according to the invention, the development step is conducted by a monobath development processing with the developer described above. The term "monobath development processing" as used herein means that processings ordinarily necessary for development are conducted by a monobath at the same time. Specifically, conventional processing process comprises removing a protective layer in pre-water washing, conducting alkali development, removing the alkali in post-water washing and conducting gumming treatment. On the contrary, the method according to the invention is characterized by conducting the development and gumming at the same time in a monobath using the developer described above. Thus, the post-water washing is not necessary, and after conducting the monobath development processing, drying (including natural drying) can be performed. Moreover, since the removal of protective layer can also be conducted simultaneously with the development processing, the pre-water washing is also unnecessary. It is preferred that after the development processing, the excess developer is removed using a squeeze roller or the like, followed by conducting drying.

The development step can be preferably performed by an automatic processor equipped with a rubbing member. As the automatic processor, there are illustrated an automatic processor in which a lithographic printing plate precursor after imagewise exposure is subjected to a rubbing treatment while it is transporting described in JP-A-2-220061 and JP-A-60-59351, and an automatic processor in which a lithographic printing plate precursor after imagewise exposure placed on a cylinder is subjected to a rubbing treatment while rotating the cylinder described in U.S. Patents 5,148,746 and 5,568,768 and British Patent 2,297,719. Among them, an automatic processor using a rotating brush roller as the rubbing member is particularly preferred.

The rotating brush roller which can be preferably used in the invention can be appropriately selected by taking account, for example, of scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-UM-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.

As the brush material, a plastic fiber (for example, a polyester-based synthetic fiber, e.g., polyethylene terephthalate or polybutylene terephthalate, a polyamide-based synthetic fiber, e.g., nylon 6.6 or nylon 6.10, a polyacrylic synthetic fiber, e.g., polyacrylonitrile or polyalkyl (meth)acrylate and a polyolefin-based synthetic fiber, e.g., polypropylene or polystyrene can be used. For instance, a brush material having a fiber bristle diameter of 20 to 400 µm and a bristle length of 5 to 30 mm can be preferably used.

The outer diameter of the rotating brush roller is preferably from 30 to 200 mm, and the peripheral velocity at the tip of the brush rubbing the plate surface is preferably from 0.1 to 5 m/sec. It is preferred to use a plurality of the rotating brush rollers.

The rotating direction of the rotating brush roller may be the same direction or the opposite direction with respect to the transporting direction of the lithographic printing plate precursor, but when two or more rotating brush rollers are used, it is preferred that at least one rotating brush roller rotates in the same direction and at least one rotating brush roller rotates in the opposite direction with respect to the transporting direction. By such arrangement, the photosensitive layer in the non-image area can be more steadily removed. Further, a technique of rocking the rotating brush roller in the rotation axis direction of the brush roller is also effective.

An example of the structure of automatic processor preferably used in the method of preparing a lithographic printing plate according to the invention is schematically shown in Fig. 1. In the automatic processor shown in Fig. 1, an imagewise exposed lithographic printing plate precursor 104 is transported in a developer 107 while rubbing the surface thereof with a rubbing member 112, thereby conducting development processing.

In the case of conducting the development processing using an automatic developing machine, the developer becomes fatigued in accordance with the processing amount, and hence the processing ability may be restored using a replenisher or a fresh developer.

After the development step, a drying step is preferably provided continuously or discontinuously. The drying is conducted using, for example, hot air, an infrared ray or a far-infrared ray.

In the method of preparing a lithographic printing plate according to the invention, the entire surface of the lithographic printing plate precursor may be heated between the exposure and the development, if desired. By the heating, the image-forming reaction in the image-recording layer is accelerated and advantages, for example, improvement in the sensitivity and printing durability and stabilization of the sensitivity may be achieved.

The conditions of the heating can be appropriately determined in a range for providing such effects. Examples of the heating means include a conventional convection oven, an IR irradiation apparatus, an IR laser, a microwave apparatus or a Wisconsin oven. For instance, the heat treatment can be conducted by maintaining the lithographic printing plate precursor at a plate surface temperature ranging from 70 to 150°C for a period of one second to 5 minutes, preferably at 80 to 140°C for 5 seconds to one minute, more preferably at 90 to 130°C for 10 to 30 seconds. In the above-described range, the effects described above are efficiently achieved and an adverse affect, for example, change in shape of the lithographic printing plate precursor due to the heat can be preferably avoided.

It is preferable that heat treatment means used in the heat treatment step is connected with a plate setter used in the exposure step and a development apparatus used in the development processing step and the lithographic printing plate precursor is subjected to automatically continuous processing. Specifically, a plate making line wherein the plate setter and the development apparatus are connected with each other by transport means, for example, a conveyer is illustrated. Also, the heat treatment means may be placed between the plate setter and the development apparatus or the heat treatment means and the development apparatus may constitute a unit apparatus.

In case where the lithographic printing plate precursor used is apt to be influenced by surrounding light under a working environment, it is preferable that the plate making line is blinded by a filter, a cover or the like.

The entire surface of lithographic printing plate after development may be exposed to active ray, for example, ultraviolet light to accelerate curing of the image area. As a light source for the entire surface exposure, for example, a carbon arc lamp, a mercury lamp, a gallium lamp, a metal halide lamp, a xenon lamp, a tungsten lamp or various laser beams is exemplified. In order to obtain sufficient printing durability, the amount of the entire surface exposure is preferably 10 mJ/cm² or more, and more preferably 100 mJ/cm² or more.

Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150°C, more preferably from 35 to 130°C, and still more preferably from 40 to 120°C. Specifically, a method described in JP-A-2000-89478 can be used.

Further, for the purpose of increasing printing durability, the lithographic printing plate after development can be heated under very strong conditions. The heat temperature is ordinarily in a range of 200 to 500°C. When the temperature is too low, a sufficient effect of strengthening the image may not be obtained, whereas when it is excessively high, problems of deterioration of the support and thermal decomposition of the image area may occur sometimes.

The lithographic printing plate thus-obtained is mounted on an off-set printing machine to use for printing a large number of sheets.

### EXAMPLES

The present invention will be described in more detail with reference to the following examples, but the invention should not be construed as being limited thereto.

### Examples 1 to 32 and Comparative Examples 1 to 3

### [Preparation of support]

An aluminum plate (JIS A1050) having a thickness of 0.3 mm was subjected to surface treatment according to the steps shown below.

### (a) Mechanical surface roughening treatment

Mechanical surface roughening of the aluminum plate was conducted by means of rotating roller-form nylon brushes while supplying a suspension (having specific gravity of 1.12) of an abrasive (pumice) in water as an abrasion slurry liquid to the surface of the aluminum plate. The average particle size of the abrasive was 30 µm and the maximum particle size was 100 µm. The material of the nylon brush was 6-10 nylon and the brush has a bristle length of 45 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) were provided under the brush rollers at 300 mm intervals. The brush rollers were pressed against the aluminum plate till the load applied to a driving motor for rotating the brush became 7 kW greater than the load before pressing the brush rollers against the aluminium plate. The rotating direction of the brushes was the same as the moving direction of the aluminum plate. The rotation number of the brushes was 200 rpm.

### (b) Alkali etching treatment

Alkali etching treatment of the aluminum plate was conducted by spraying an aqueous solution having sodium hydroxide concentration of 26% by weight, aluminum ion concentration of 6.5% by weight and temperature of 70°C to dissolve the aluminum plate in an amount of 10 g/m², followed by washing with water by spraying.

### (c) Desmut treatment

Desmut treatment of the aluminum plate was conducted by spraying an aqueous nitric acid solution having temperature of 30°C, followed by washing with water by spraying. As the aqueous nitric acid solution for the desmut treatment, a waste solution from a step of conducting electrochemical surface roughening treatment using alternating current in an aqueous nitric acid solution was used.

### (d) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by weight of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric quantity was 220 C/dm² in terms of the total electric quantity during the aluminum plate functioning as an anode. To the auxiliary anode, 5% of the current from the electric source was divided. Subsequently, the plate was washed with water by spraying.

### (e) Alkali etching treatment

Alkali etching treatment of the aluminum plate was conducted at 35°C by spraying an aqueous solution having a sodium hydroxide concentration of 26% by weight and an aluminum ion concentration of 6.5% by weight to dissolve the aluminum plate in an amount of 0.50 g/m². Thus, the smut component mainly comprising aluminum hydroxide formed in the precedent step of electrochemical surface roughening treatment using alternating current was removed and an edge portion of the pit formed was dissolved to smoothen the edge portion. Subsequently, the plate was washed with water by spraying.

### (f) Desmut treatment

Desmut treatment of the aluminum plate was conducted by spraying an aqueous 15% by weight sulfuric acid solution (containing 4.5% by weight of aluminum ion) having temperature of 30°C, followed by washing with water by spraying.

### (g) Electrochemical surface roughening treatment

Electrochemical surface roughening treatment of the aluminum plate was continuously conducted by applying 60 Hz alternating current voltage. The electrolytic solution used was an aqueous solution containing 5.0 g/liter of hydrochloric acid (containing 5 g/liter of aluminum ion) and the solution temperature was 35°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 25 A/dm² at the peak current, and the electric quantity was 50 C/dm² in terms of the total electric quantity during the aluminum plate functioning as an anode. Subsequently, the plate was washed with water by spraying.

### (h) Alkali etching treatment

Alkali etching treatment of the aluminum plate was conducted by spraying an aqueous solution having sodium hydroxide concentration of 5% by weight, aluminum ion concentration of 0.5% by weight and temperature of 50°C, followed by washing with water by spraying.

### (i) Desmut treatment

Desmut treatment of the aluminum plate was conducted at 35°C for 4 seconds. As an aqueous sulfuric acid solution for the desmut treatment, a waste solution generated in a step of anodizing treatment was used.

### (j) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2.4 m each). The electrolytic solution supplied to the first electrolytic unit and second electrolytic unit was an aqueous solution having sulfuric acid concentration of 50 g/liter (containing 0.5% by weight of aluminum ion) and the solution temperature was 20°C. Subsequently, the plate was washed with water by spraying. The amount of the final anodic oxide film was 2.7 g/m².

### (k) Treatment with polyvinylphosphonic acid

The aluminum plate was immersed in an aqueous solution containing 4 g/liter of polyvinylphosphonic acid at 40°C for 10 seconds, washed with demineralized water having calcium ion concentration of 75 ppm at 20°C and then with pure water at 20°C and dried. The adsorption amount of calcium ion was adjusted by varying the washing times with demineralized water and pure water as shown below.

| Washing Time with Demineralized Water | Washing Time with Pure Water | Absorption Amount of Calcium Ion |
|---|---|---|
| none | 4 seconds | 0 mg/m² |
| 2 seconds | 10 seconds | 0.28 mg/m² |
| 2 seconds | 6 seconds | 0.88 mg/m² |
| 2 seconds | 4 seconds | 1.13 mg/m² |
| 2 seconds | 2 seconds | 1.48 mg/m² |
| 4 seconds | 6 seconds | 1.76 mg/m² |
| 4 seconds | 4 seconds | 1.92 mg/m² |
| 6 seconds | 4 seconds | 2.40 mg/m² |
| 6 seconds | 2 seconds | 3.20 mg/m² |

The aluminum plate subjected to conducting all steps (a) to (k) was referred to as Support 1. The aluminum plate subjected to conducting only steps (e) to (k) was referred to as Support 2. The aluminum plate subjected to conducting steps (b) to (d) and (h) to (k) was referred to as Support 3. The center line average roughness (Ra indication according to JIS B0601) of each support was measured using a stylus having a diameter of 2 µm and it was found that the center line average roughness of Support 1, Support 2 and Support 3 were 0.52 µm, 0.28 µm and 0.25 µm, respectively.

### [Formation of photosensitive layer]

### (Photosensitive layer 1)

Coating solution 1 for photosensitive layer having the composition shown below was coated on a support using a bar and dried by a hot air drying device at 100°C for one minute to form Photosensitive layer 1 having a dry coating amount of 1.4 g/m².

### <Coating solution 1 for photosensitive layer>

| | |
|---|---|
| Polymerizable Compound (M-1) shown below | 3.6 parts by weight |
| Binder Polymer (B-1) shown below (weight average molecular weight: 47,000) | 2.4 parts by weight |
| Sensitizing Dye (D-1) shown below | 0.32 parts by weight |
| Polymerization Initiator (I-1) shown below | 0.61 parts by weight |
| Chain Transfer Agent (S-2) shown below | 0.57 parts by weight |
| N-Nitrosophenylhydroxylamine aluminum salt | 0.020 part by weight |
| Dispersion of ε-phthalocyanine | 0.71 parts by weight |
| Fluorine-Based Surfactant (F-1) shown below (weight average molecular weight: 11,000) | 0.016 part by weight |
| Methyl ethyl ketone | 47 parts by weight |
| Propylene glycol monomethyl ether | 45 parts by weight |

The structures of Polymerizable compound (M-1), Binder Polymer (B-1), Sensitizing Dye (D-1), Polymerization Initiator (I-1), Chain Transfer Agent (S-2) and Fluorine-Based Surfactant (F-1) used in Coating solution 1 for photosensitive layer are shown below, respectively. M-1

Mixture of the following compounds:

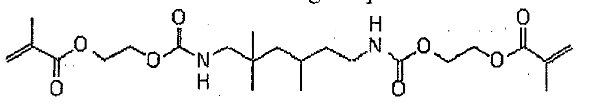

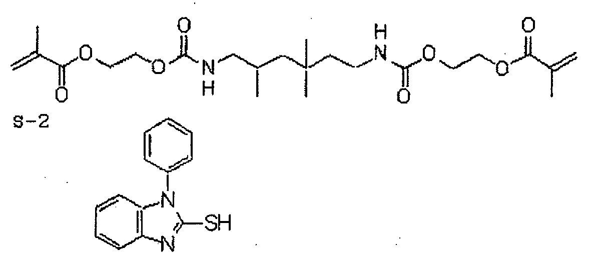

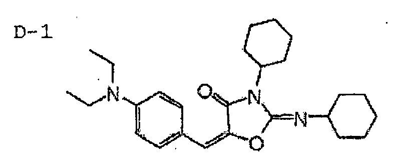

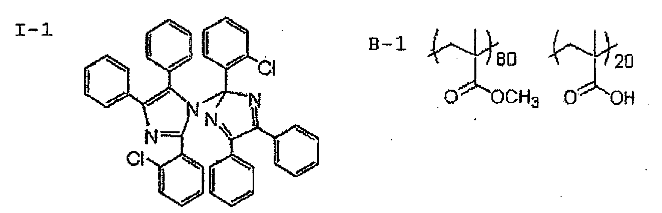

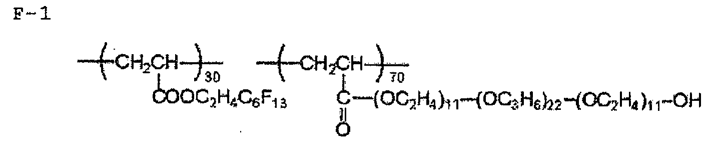

### (Photosensitive layer 2)

Coating solution 2 for photosensitive layer having the composition shown below was coated on a support using a bar and dried by a hot air drying device at 125°C for 34 seconds to form Photosensitive layer 2 having a dry coating amount of 1.4 g/m².

### (Coating solution 2 for photosensitive layer)

| | |
|---|---|
| Infrared Absorbing Agent (IR-1) shown below | 0.038 g |
| Polymerization Initiator A (S-1) shown below | 0.061 g |
| Polymerization Initiator B (I-2) shown below | 0.094 g |
| Mercapto Compound (E-1) shown below | 0.015 g |
| Polymerizable Compound (M-2) shown below | 0.629 g |
| (trade name: A-BPE-4, produced by Shin-Nakamura Chemical Co., Ltd.) | |
| Binder Polymer (B-1) shown above | 0.419 g |
| Additive (T-1) shown below | 0.079 g |
| Polymerization Inhibitor (Q-1) shown below | 0.0012 g |
| Ethyl Violet (EV-1) shown below | 0.021 g |
| Fluorine-Based Surfactant (F-1) shown above | 0.0081 g |
| Methyl ethyl ketone | 5.886 g |
| Methanol | 2.733 g |
| 1-Methoxy-2-propanol | 5.886 g |

The structures of Infrared Absorbing Agent (IR-1), Polymerization Initiator A (S-1), Polymerization Initiator B (I-2), Mercapto Compound (E-1), Polymerizable Compound (M-2), Additive (T-1), Polymerization Inhibitor (Q-1) and Ethyl Violet (EV-1) used in Coating solution 2 for photosensitive layer are shown below, respectively.

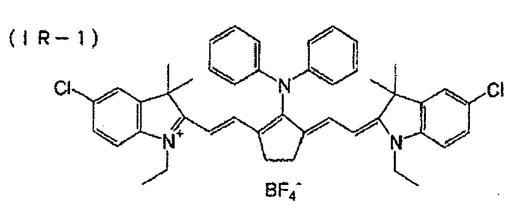

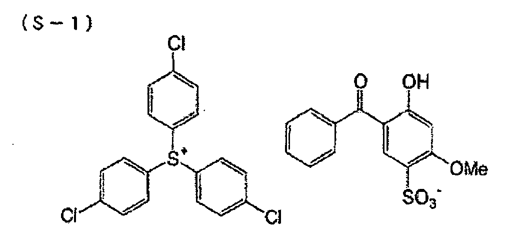

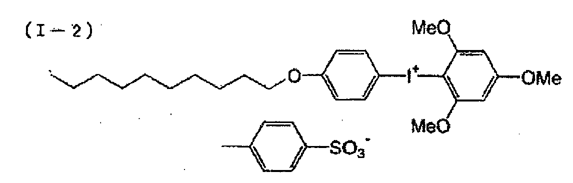

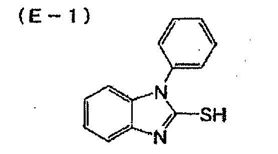

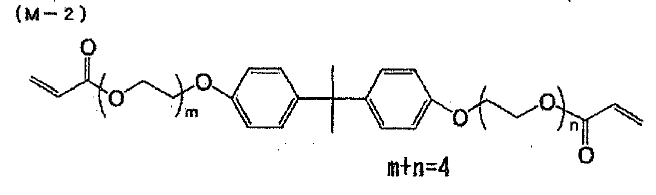

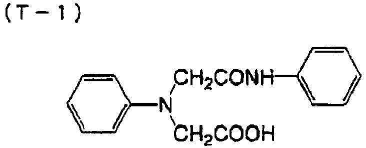

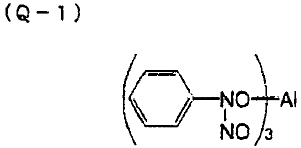

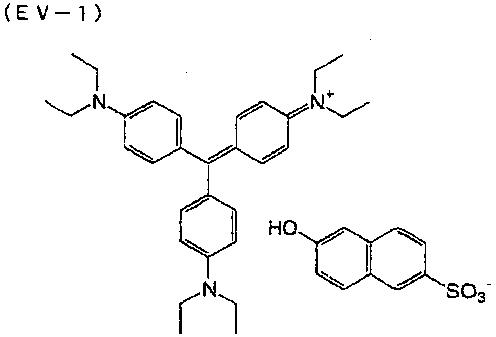

### (Photosensitive layer 3)

Coating solution 3 for photosensitive layer having the composition shown below was coated on a support using a bar and dried by a hot air drying device at 125°C for 34 seconds to form Photosensitive layer 3 having a dry coating amount of 1.4 g/m².

### <Coating solution 3 for photosensitive layer>

| | |
|---|---|
| Polymerizable Compound (M-1) shown above | 4.68 parts by weight |
| Binder Polymer (B-1) shown above | 3.12 parts by weight |
| Infrared Absorbing Agent (IR-1) shown above | 0.31 parts by weight |
| Onium Salt (OS-12) shown below | 1.2 parts by weight |
| Dispersion of ε-phthalocyanine | 0.92 parts by weight |
| Fluorine-based nonionic surfactant (Megafac^{®} 780, produced by Dainippon Ink and Chemicals, Inc.) | 0.05 parts by weight |
| Methyl ethyl ketone | 62 parts by weight |
| Propylene glycol monomethyl ether acetate | 57 parts by weight |

The structure of Onium Salt (OS-12) used in Coating solution 3 for photosensitive layer is shown below.

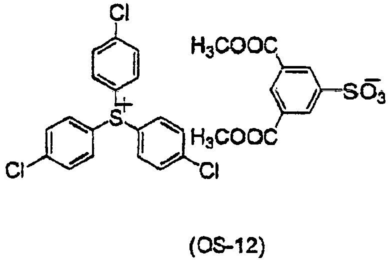

### (Photosensitive layer 4)

Coating solution 4 for photosensitive layer was prepared in the same as in Coating solution 1 for photosensitive layer except for changing Sensitizing Dye (D-1), Polymerizable Compound (M-1) and Binder Polymer (B-1) to Sensitizing Dye (D-2), Polymerizable Compound (M-3) and Binder Polymer (B-2), coated on a support using a bar and dried by a hot air drying device at 90°C for 60 seconds to form Photosensitive layer 4 having a dry coating amount of 13 g/m².

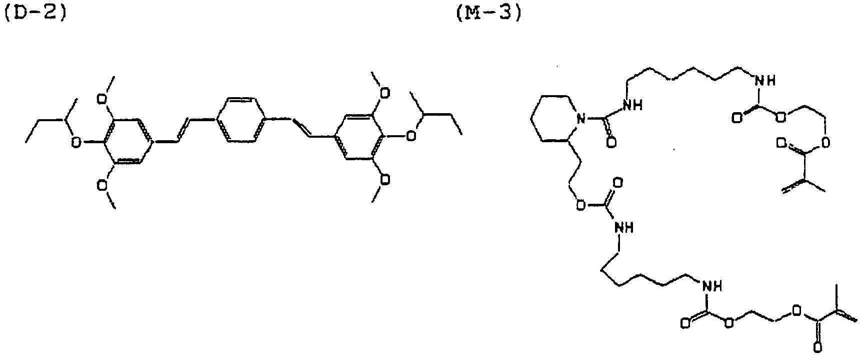

### (B-2)

Copolymer of vinyl butyral/vinyl alcohol/vinyl acetate esterified with trimellitic acid in 13.9 % based on weight (Koma30^{®}, produced by Claliant Co., Ltd.)

### [Formation of protective layer]

### (Protective layer 1)

Coating solution 1 for protective layer having the composition shown below was coated on a photosensitive layer using a bar and dried by a hot air drying device at 120°C for one minute to form Protective layer 1 having a dry coating amount of 2.5 g/m².

### (Coating solution 1 for protective layer)

| | |
|---|---|
| PVA 105 (saponification degree: 98% by mole, produced by Kuraray Co., Ltd.) | 1.80 parts by weight |
| Polyvinvlpyrrolidone (K-30, produced by BASF) | 0.40 parts by weight |
| Emalex^{®}/10 (nonionic surfactant produced by Nihon Emulsion Co., Ltd.) | 0.04 parts by weight |
| Pionin^{®} D230 (surfactant, produced by Takemoto Oil & Fat Co., Ltd.) | 0.05 parts by weight |
| Vinyl acetate/vinyl pyrrolidone copolymer (Luviskol^{®} V64W, produced by BASF) | 0.06 parts by weight |
| Pure water | 36.0 parts by weight |

### (Protective layer 2)

Protective layer 2 was prepared in the same manner as in the formation of Protective layer 1 except for changing PVA 105 used in Coating solution 1 for protective layer to sulfonic. acid-modified polyvinyl alcohol (Goseran^{®} CKS-50, produced by Nippon Synthetic Chemical Industry Co., Ltd. (saponification degree: 99% by mole; average polymerization degree: 300; modification degree: about 0.4% by mole)).

### (Protective layer 3)

Coating solution 3 for protective layer having the composition shown below was coated on a photosensitive layer using a bar and dried by a hot air drying device at 125°C for 34 seconds to form Protective layer 3 having a dry coating amount of 1.4 g/m².

### (Coating solution 3 for protective layer)

| | |
|---|---|
| Dispersion of mica shown below | 0.6 g |
| Sulfonic acid-modified polyvinyl alcohol [Goseran^{®} CKS-50, produced by Nippon Synthetic Chemical Industry Co., Ltd. (saponification degree: 99% by mole; average polymerization degree: 300; modification degree: about 0.4% by mole)] | 0.8 g |
| Vinyl pyrrolidone/vinyl acetate (1/1) copolymer (molecular weight: 70,000) | 0.001 g |
| Surfactant (Emalex^{®} 710, produced by Nihon Emulsion Co., Ltd.) | 0.002 g |
| Water | 13 g |

### (Preparation of Dispersion of mica)

In 368 g of water was added 32 g of synthetic mica (SOMASIF^{®} ME-100, produced by CO-OP Chemical Co., Ltd.; aspect ratio: 1,000 or more) and the mixture was dispersed using a homogenizer until the average particle diameter (measured by a laser scattering method) became 0.5 µm to obtain Dispersion of mica.

Supports 1 to 3, Photosensitive layers 1 to 4 and Protective layers 1 to 3 described above were combined as shown in Table A below to prepare lithographic printing plate precursors.

### [Exposure and Development]

### (Exposure and development of lithographic printing plate precursor having Photosensitive layer 1 or 4)

### <Exposure>

Image exposure was conducted under conditions of exposure amount of 90 µJ/cm² and resolution of 2,438 dpi (dpi means a number of dots per 2.54 cm). As an exposure pattern, square dot of 50% was used. As an exposure apparatus, Violet Semiconductor Laser Plate Setter Vx9600 (equipped with InGaN semiconductor laser; emission wavelength: 405 nm ± 10 nm/output: 30 mW) produced by Fuji Film Electronic Imaging, Ltd. was used.

### <Development>

The exposed lithographic printing plate precursor was pre-heated at 100°C for 30 seconds and subjected to development processing in an automatic development processor having a structure as shown in Fig. 1 using a developer having the composition shown below as shown in Table A in the following manner. Specifically, liquid temperature of a developer 107 was maintained at 28°C. Driving speed of transport rollers was set so as to take transit time of 15 seconds from carrying-in of a lithographic printing plate precursor 104 by a pair of transport rollers 108 positioned at an inlet of a developing bath 106 to carrying-out of the lithographic printing plate precursor by a pair of transport rollers 108 positioned at an outlet of the developing bath 106. As a rubbing member 112. a brush roller which had an outer diameter of 50 mm and being implanted with fiber of nylon 6.12 (bristle diameter: 75 µm, bristle length: 8.5 mm) was used and the brush roller was rotated at 150 rpm in the same direction as the transporting direction. The lithographic printing plate precursor discharged form the developing bath 106 was naturally dried.

### (Exposure and development of lithographic printing plate precursor having Photosensitive layer 2 or 3)

### <Exposure>

Image exposure was conducted by Trendsetter^{®} 3244VX (produced by Creo Co.) equipped with a water-cooled 40 W infrared semiconductor laser under the conditions of output of 9 W, a rotation number of an outer surface drum of 210 rpm and resolution of 2,400 dpi. As an exposure pattern, square dot of 50% was used.

### <Development>

The exposed lithographic printing plate precursor was subjected to development processing in an automatic development processor having a structure as shown in Fig. 1 using a developer having the composition shown below as shown in Table A in the following manner. Specifically, liquid temperature of a developer 107 was maintained at 28°C. Driving speed of transport rollers was set so as to take transit time of 15 seconds from installation of a lithographic printing plate precursor 104 by a pair of transport rollers 108 positioned at an inlet of a developing bath 106 to discharge of the lithographic printing plate precursor by a pair of transport rollers 108 positioned at an outlet of the developing bath 106. As a rubbing member 112, a brush roller which had an outer diameter of 50 mm and being implanted with fiber of nylon 6.12 (bristle diameter 75 µm, bristle length: 8.5 mm) was used and the brush roller was rotated at 150 rpm in the same direction as the transporting direction. The lithographic printing plate precursor discharged form the developing bath 106 was naturally dried.

The compositions of the developers used are shown below.

### <Developers 1 to 6>

| | |
|---|---|
| Water | 90 g |
| Surfactant shown below | 5 g |
| Sodium carbonate | 2 g |
| Sodium hydrogen carbonate | 0.8 g |
| Gum arabic | 1 g |
| Ammonium primary phosphate | 0.05 g |
| Citric acid | 0.05 g |
| Tetrasodium ethylenediaminetetraacetate | 0.05 g |

In Developers 1 to 3, Surfactants W1 to W3 shown below were used respectively. Developers 4 to 6 were prepared by eliminating 1 g of gum arabic from Developers 1 to 3 and adding 1 g of water to Developers 1 to 3 respectively. Depending on the kind of surfactant, the amount of sodium hydrogen carbonate added was finely adjusted to control pH of the developer to 9.8.
Surfactant W1: Pionin^{®} C-157K, produced by Takemoto Oil & Fat Co., Ltd.

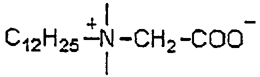

Surfactant W2: Eleminol^{®} MON 2, produced by Sanyo Chemical Industries, Ltd.

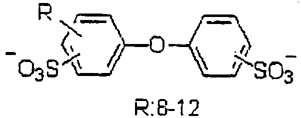

Surfactant W3: Newcol^{®} B13, produced by Nippon Nyukazai Co., Ltd.

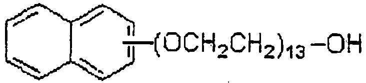

### <Developer 7>

| | |
|---|---|
| Hydroxy-alkylated starch (Penon^{®} JE66, produced by Nippon Starch Chemical Co., Ltd.) | 55 g |
| Surfactant W2 | 30 g |
| Chelating agent: trisodium ethylenediaminesuccinate (Octaquest^{®} E30, produced by Innospec Specialty Chemicals Ltd.) | 6.8 g |
| 2-Bromo-2-nitropropane-1,3-diol | 0.075 g |
| 2-Methyl-4-isothiazolin-3-one | 0.075 g |
| Silicone-type deforming agent (TSA 739, produced by GE Toshiba Silicones Co., Ltd.) | 1.0 g |
| Glycine | 7.5 g |
| Water | 899.55 g |
| Sodium hydroxide | 2.24 g |

### <Developer 8>

Developer 8 was prepared by eliminating 55 g of hydroxy-alkylated starch from Developer 7 and adding 55 g of water to Developer 7.

### <Developer 9>

| | |
|---|---|
| Surfactant W2 | 30 g |
| Chelating agent: trisodium ethylenediaminesuccinate (Octaquest^{®} E30, produced by Innospec Specialty Chemicals Ltd.) | 6.8 g |
| 2-Bromo-2-nitropropane-1,3-diol | 0.075 g |
| 2-Methyl-4-isothiazolin-3-one | 0.075 g |
| Silicone-type deforming agent (TSA 739, produced by GE Toshiba Silicones Co., Ltd.) | 1.0 g |
| Iminodiacetic acid | 13.3 g |
| Water | 948.75 g |
| Sodium hydroxide | 7.2 g |

### <Developer 10>

| | |
|---|---|
| Hydroxy-alkylated starch (Penon^{®} JE66, produced by Nippon Starch Chemical Co., Ltd.) | 55 g |
| Surfactant W2 | 30 g |
| Chelating agent: trisodium ethylenediaminesuccinate (Octaquest^{®} E30, produced by Innospec Specialty, Chemicals Ltd.) | 6.8 g |
| 2-Bromo-2-nitropropane-1,3-diol | 0.075 g |
| 2-Methyl-4-isothiazolin-3-one | 0.075 g |
| Silicone-type deforming agent (TSA 739, produced by GE Toshiba Silicones Co.. Ltd.) | 1.0 g |
| Triethanolamine | 29.8 g |
| Water | 877.25 g |
| 1 mol/liter hydrochloric acid | 3.5 g |

### <Developer 11>

Developer 11 was prepared by eliminating 55 g of hydroxy-alkylated starch from Developer 10 and adding 55 g of water to Developer 10.

### <Developer 12>

| | |
|---|---|
| Hydroxy-alkylated starch (Penon^{®} JE66, produced by Nippon Starch Chemical Co., Ltd.) | 55 g |
| Surfactant W2 | 30 g |
| Chelating agent: trisodium ethylenediaminesuccinate (Octaquest^{®} E30, produced by Innospec Specialty Chemicals Ltd.) | 6.8 g |
| 2-Bromo-2-nitropropane-1,3-diol | 0.075 g |
| 2-Methyl-4-isothiazolin-3-one | 0.075 g |
| Silicone-type deforming agent (TSA 739, produced by GE Toshiba Silicones Co., Ltd.) | 1.0 g |
| Boric acid (orthoboric acid) | 11.5 g |
| Sodium hydroxide | 5.98 g |
| Water | 890.1 g |

### <Developer 13>

| | |
|---|---|
| Water | 88 g |
| Anionic surfactant (Eleminol^{®} MON 2, produced by Sanyo Chemical Industries, Ltd) | 3 g |
| Anionic surfactant (Pionin^{®} A-41-S, produced by Takemoto Oil & Fat Co., Ltd.) | 2 g |
| Sodium carbonate | 2 g |
| Sodium hydrogen carbonate | 0.8 g |
| Gum arabic | 1 g |
| Ammonium primary phosphate | 0.05 g |
| Citric acid | 0.05 g |
| Tetrasodium ethylenediaminetetraacetate | 0.05 g |

### <Developer 14>

Developer 14 was prepared by finely adjusting the amount of sodium hydrogen carbonate added to Developer 1 to control pH of the developer to 9.0.

### <Developer 15>

Developer 15 was prepared by finely adjusting the amount of sodium hydrogen carbonate added to Developer 1 to control pH of the developer to 10.5.

### <Developer 16>

| | |
|---|---|
| Water | 88 g |
| Amphoteric surfactant (Softazoline^{®} PB-R, produced by Kawaken Fine Chemicals, Co., Ltd.) | 3 g |
| Sodium carbonate | 2 g |
| Sodium hydrogen carbonate | 0.8 g |
| Gum arabic | 1 g |
| Ammonium primary phosphate | 0.05 g |
| Sodium gluconate | 0.05 g |
| Tetrasodium ethylenediaminetetraacetate | 0.05 g |

### <Developer 17>

Developer 17 was prepared by using an amphoteric surfactant (Softazoline^{®} LAO, produced by Kawaken Fine Chemicals, Co., Ltd.) in place of the amphoteric surfactant (Softazoline^{®} LPB-R) in Developer 16.

### <Developer 18>

| | |
|---|---|
| Water | 88.6 g |
| Nonionic surfactant W4 | 2.4 g |
| Nonionic surfactant W5 | 2.4 g |
| Nonionic surfactant (Emalex^{®} 710, produced by Nihon Emulsion Co., Ltd.) | 1.0 g |
| Phenoxypropanol | 1.0 g |
| Octanol | 0.6 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (Versa^{®} TL77 (30% solution) produced by Alco Chemical Inc.) | 1.0 g |

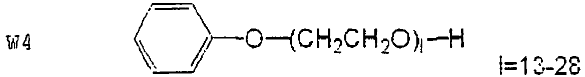

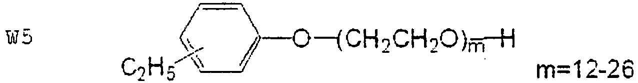

### <Developer 19>

Developer 19 was prepared by adding phosphoric acid to Developer 18 to control pH to 7.0.

### <Developer 20>

| | |
|---|---|
| Water | 100 g |
| Pionin^{®} C-157K- produced by Takemoto Oil & Fat Co., Ltd. | 10 g |
| Gum arabic (Mw: 250,000) | 1 g |
| Ammonium primary phosphate | 0.05 g |
| Citric acid | 0.05 g |
| Tetrasodium ethylenediaminetetraacetate | 0.05 g |

### [Printing]

The lithographic printing plate thus-obtained was mounted on a printing machine (Lithrone^{®}, produced by Komori Corp.) and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G(N) black ink (produced by Dainippon Ink & Chemicals. Inc.).

### [Evaluation]

Using each of the lithographic printing plate precursors, preservation stability, printing durability and stain resistance were evaluated in the following manner.

### <Preservation stability>

The lithographic printing plate precursor before exposure was preserved under conditions of temperature of 60°C and humidity of 50% for 3 days and then exposed and developed as described above to obtain a lithographic printing plate. A halftone dot area of the lithographic printing plate was measured using ccDot produced by S.D.G K.K. and compared with a halftone dot area obtained in a case where the preservation was not conducted to calculate a difference in the halftone dot area which was used as an index of the preservation stability. As the absolute value of the difference in the halftone dot area with and without the preservation is small (closer to 0), the preservation stability is better. The results obtained are shown in Table A.

### <Printing durability>

The above-described exposure was conducted with linear correction and halftone dot images of 1 to 99% were reproduced linearly on a lithographic printing plate. The lithographic printing plate was subjected to the printing as described above and a number of printed materials in which 3% halftone dot could not be reproduced was used as an index of the printing durability. As the number of printed materials increases, the printing durability is better. The results obtained are shown in Table A.

### <Stain resistance>

Before the initiation of printing, an ink supplying roller was brought into contact with a surface of the lithographic printing plate so as to adhere the ink on the entire surface of lithographic printing plate and then the printing described above was initiated. A number of printed materials in which the stain in the non-image area could be completely removed was used as an index of the stain resistance. As the number of printed materials is small, the stain resistance is better. The results obtained are shown in Table A.

**TABLE A**

| | Cation | Adsorption Amount of Ca Ion (mg/m²) | Support | Photosensitive Layer | Protective Layer | Developer | pH of Developer | Preservation Stability (Difference in sensitivity (%)) | Stain Resistance (sheets) | Printing Durability (x10⁴ sheets) |
|---|---|---|---|---|---|---|---|---|---|---|
| Example 1 | Ca | 0.88 | 3 | 1 | 3 | 5 | 9.8 | 2.5 | 50 | 5.8 |
| Example 2 | Ca | 1.13 | 3 | 1 | 3 | 5 | 9.8 | 2.0 | 40 | 6.4 |
| Example 3 | Ca | 1.48 | 3 | 1 | 3 | 5 | 9.8 | 1.5 | 35 | 6.7 |
| Example 4 | Ca | 1.76 | 3 | 1 | 3 | 5 | 9.8 | 1.0 | 30 | 7.5 |
| Example 5 | Ca | 1.92 | 1 | 1 | 3 | 5 | 9.8 | 0.5 | 25 | 7.3 |
| Example 6 | Ca | 1.92 | 2 | 1 | 3 | 5 | 9.8 | 0.5 | 25 | 7.5 |
| Example 7 | Ca | 1.92 | 3 | 1 | 3 | 5 | 9.8 | 0.5 | 25 | 7.0 |
| Example 8 | Ca | 1.92 | 3 | 2 | 3 | 5 | 9.8 | 0.5 | 25 | 7.2 |
| Example 9 | Ca | 1.92 | 3 | 3 | 3 | 5 | 9.8 | 0.5 | 25 | 7.0 |
| Example 10 | Ca | 2.40 | 3 | 1 | 3 | 5 | 9.8 | 1.0 | 25 | 6.5 |
| Example 11 | Ca | 1.92 | 3 | 1 | 3 | 5 | 9.8 | 0.5 | 25 | 7.9 |
| Example 12 | Ca | 1.92 | 3 | 1 | 1 | 5 | 9.8 | 0.5 | 25 | 7.5 |
| Example 13 | Ca | 1.92 | 3 | 1 | 2 | 5 | 9.8 | 0.5 | 25 | 7.1 |
| Example 14 | Ca | 1.92 | 3 | 1 | 3 | 1 | 9.8 | 0.5 | 25 | 7.1 |
| Example 15 | Ca | 1.92 | 3 | 1 | 3 | 2 | 9.8 | 0.5 | 25 | 7.0 |
| Example 16 | Ca | 1.92 | 3 | 1 | 3 | 3 | 9.8 | 0.5 | 25 | 7.6 |
| Example 17 | Ca | 1.92 | 3 | 1 | 3 | 4 | 9.8 | 0.5 | 25 | 7.7 |
| Example 18 | Ca | 1.92 | 3 | 1 | 3 | 6 | 9.8 | 0.5 | 25 | 7.8 |
| Example 19 | Ca | 1.92 | 3 | 1 | 3 | 7 | 9.8 | 0.5 | 25 | 7.0 |
| Example 20 | Ca | 1.92 | 3 | 1 | 3 | 8 | 9.8 | 0.5 | 25 | 7.8 |
| Example 21 | Ca | 1.92 | 3 | 1 | 3 | 9 | 9.8 | 0.5 | 25 | 7.4 |
| Example 22 | Ca | 1.92 | 3 | 1 | 3 | 10 | 9.8 | 0.5 | 25 | 7.6 |
| Example 23 | Ca | 1.92 | 3 | 1 | 3 | 11 | 9.8 | 0.5 | 25 | 7.1 |
| Example 24 | Ca | 1.92 | 3 | 1 | 3 | 12 | 9.8 | 0.5 | 25 | 7.0 |
| Example 25 | Ca | 1.92 | 3 | 1 | 3 | 13 | 9.8 | 0.5 | 25 | 7.1 |
| Example 26 | Ca | 1.92 | 3 | 1 | 3 | 14 | 9.0 | 0.5 | 25 | 7.1 |
| Example 27 | Ca | 1.92 | 3 | 1 | 3 | 15 | 10.5 | 0.5 | 25 | 6.1 |
| Example 28 | Ca | 1.92 | 3 | 1 | 3 | 16 | 9.8 | 0.5 | 25 | 7.2 |
| Example 29 | Ca | 1.92 | 3 | 1 | 3 | 17 | 9.8 | 0.5 | 25 | 7.2 |
| Example 30 | Ca | 1.92 | 3 | 4 | 1 | 18 | 94 | 0.5 | 25 | 7.6 |
| Example 31 | Ca | 1.92 | 3 | 4 | 1 | 19 | 7.0 | 0.5 | 25 | 7.9 |
| Example 32 | Ca | 1.92 | 3 | 1 | 3 | 20 | 45 | 0.5 | 60 | 8.3 |
| Comparative Example 1 | Ca | 0.00 | 3 | 1 | 3 | 5 | 9.8 | 6.0 | 150 | 1.8 |
| Comparative Example 2 | Ca | 0.28 | 3 | 1 | 3 | 5 | 98 | 4.0 | 80 | 3.5 |
| Comparative Example 3 | Ca | 3.20 | 3 | 1 | 3 | 5 | 98 | 4.5 | 40 | 2.6 |

As is apparent from the results shown in Table A, according to the invention a lithographic printing plate precursor excellent in the preservation stability can be provided and a method of preparing a lithographic printing plate excellent in the printing durability and stain resistance can be provided in spite of a monobath development processing.

## Claims

1. A method for preparing a lithographic printing plate comprising:
imagewise exposing a lithographic printing plate precursor (104) comprising a photosensitive layer containing a sensitizing dye, a polymerization initiator, a polymerizable compound and a binder polymer and an aluminum support on which a divalent cation is adsorbed in an amount of from 0.5 to 3.0 mg/m² prepared by treating the aluminum support with an aqueous polyvinylphosphonic acid solution and washing the treated aluminum support with an aqueous solution containing the divalent cation; and
subjecting the exposed lithographic printing plate precursor to development processing in a monobath (106) with a Developer (107) which has a pH of from 2 to 11 and which comprises a pH buffer agent and a surfactant.

2. A method according to claim 1, wherein the pH buffer agent is a combination of a carbonate ion.and a hydrogen carbonate ion.

3. A method according to claim 1 or Claim 2, wherein the developer comprises a water-soluble resin.

4. A method according to any preceding claim, wherein the sensitizing dye is a dye having an absorption maximum in the wavelength range of from 350 to 450 nm.

5. A method according to any preceding claim, wherein the sensitizing dye is a dye having an absorption maximum in the wavelength range of from 750 to 1,400 nm.

6. A method according to any preceding claim, wherein the polymerizable compound has at least one of a urea group and a tertiary amino group.

## Patentansprüche

1. Verfahren zur Herstellung einer Lithografiedruckplatte, umfassend:
bildweises Belichten eines Lithografiedruckplattenvorläufers (104), der eine fotoempfindliche Schicht, die einen Sensibilisierungsfarbstoff, einen Polymerisationsinitiator, eine polymerisierbare Verbindung und ein Binderpolymer enthält, und einen Aluminiumträger, auf dem ein divalentes Kation in einer Menge von 0,5 bis 3,0 mg/m² adsorbiert ist, hergestellt durch Behandeln des Aluminiumträgers mit einer wässrigen Polyvinylphosphonsäurelösung und Waschen des behandelten Aluminiumträgers mit einer wässrigen Lösung, die das divalente Kation enthält, umfasst; und
Unterziehen des belichteten Lithografiedruckplattenvorläufers unter eine Entwicklungsverarbeitung in einem Monobad (106) mit einem Entwickler (107), der einen pH-Wert von 2 bis 11 aufweist und der ein pH-Puffermittel und ein Tensid umfasst.

2. Verfahren gemäß Anspruch 1, worin das pH-Puffermittel eine Kombination eines Carbonations und eines Hydrogencarbonations ist.

3. Verfahren gemäß Anspruch 1 oder Anspruch 2, worin der Entwickler ein wasserlösliches Harz umfasst.

4. Verfahren gemäß irgendeinem vorhergehenden Anspruch, worin der Sensibilisierungsfarbstoff ein Farbstoff mit einem Absorptionsmaximum im Wellenlängenbereich von 350 bis 450 nm ist.

5. Verfahren gemäß irgendeinem vorhergehenden Anspruch, worin der Sensibilisierungsfarbstoff ein Farbstoff mit einem Absorptionsmaximum im Wellenlängenbereich von 750 bis 1.400 nm ist.

6. Verfahren gemäß irgendeinem vorhergehenden Anspruch, worin die polymerisierbare Verbindung mindestens eines von einer Harnstoffgruppe und eine tertiären Aminogruppe aufweist.

## Revendications

1. Procédé de préparation d'une plaque d'impression lithographique comprenant les étapes consistant à:
- exposer image par image un précurseur (104) de plaque d'impression lithographique comprenant une couche photosensible contenant un colorant sensibilisateur, un initiateur de polymérisation, un composé polymérisable ainsi qu'un polymère de liaison et un support en aluminium sur lequel un cation divalent est adsorbé en une quantité allant de 0,5 à 3,0 mg/m² préparée en traitant le support en aluminium avec une solution aqueuse d'acide polyvinylphosphonique et en lavant le support en aluminium traité avec une solution aqueuse contenant le cation divalent ; et
- soumettre le précurseur de plaque d'impression lithographique exposé à un traitement de développement dans un mono-bain (106) avec un développeur (107) qui a un pH allant de 2 à 11 et qui comprend un agent tampon de pH et un tensioactif.

2. Procédé selon la revendication 1, dans lequel l'agent tampon de pH est une combinaison d'un ion carbonate et d'un ion de carbonate d'hydrogène.

3. Procédé selon la revendication 1 ou la revendication 2, dans lequel le développeur comprend une résine soluble dans de l'eau.

4. Procédé selon une quelconque revendication précédente, dans lequel le colorant sensibilisateur est un colorant ayant un maximum d'absorption dans la plage de longueur d'onde allant de 350 à 450 nm.

5. Procédé selon une quelconque revendication précédente, dans lequel le colorant sensibilisateur est un colorant ayant un maximum d'absorption dans la plage de longueur d'onde allant de 750 à 1400 nm.

6. Procédé selon une quelconque revendication précédente, dans lequel le composé polymérisable a au moins un parmi un groupe urée et un groupe amino tertiaire.
